# EUROPEAN PATENT APPLICATION

(11) **EP 4 582 880 A1**
(43) Date of publication of application: **09.07.2025**
(21) Application number: 24221249.6
(22) Date of filing: 18.12.2024
(51) Int. Cl.: G04F 10/00

(54) **TIME TO DIGITAL CONVERTER, DISTANCE MEASURING APPARATUS, MOVING OBJECT, AND EQUIPMENT**

(30) Priority: 04.01.2024 JP 2024000221
(71) Applicant: CANON KABUSHIKI KAISHA, Tokyo 146-8501 (JP)
(72) Inventor: MUTO, Hiroyuki, Tokyo, 146-8501 (JP)
(74) Representative: Canon Europe Limited

(57) **Abstract**

Provided is a time to digital converter that outputs time interval digital data having multiple bits according to a time interval from a first timing to a second timing, the time to digital converter including a first circuit configured to generate lower order bits among the multiple bits, a second circuit configured to generate higher order bits among the multiple bits, and a third circuit configured to synchronize the first circuit and the second circuit by generating a second signal with use of a first signal output from the first circuit and outputting the second signal to the second circuit, in which the first signal is generated by using a signal with multiple bits among the lower order bits.

## Description

### BACKGROUND OF THE INVENTION

### Field of the Invention

The present disclosure relates to a time to digital converter, a distance measuring apparatus, a moving object, and an equipment.

### Description of the Related Art

In recent years, a time to digital converter (TDC) configured to convert a time interval into a digital signal has been used in various fields. A time to digital converter described in International Publication No. 2013/034770 is applied to a sensor capable of sensing a three-dimensional (3D) distance image and measures a time of flight of a photon detected by a single photon avalanche diode (SPAD) pixel. In addition, the time to digital converter in International Publication No. 2013/034770 includes a coarse TDC and a fine TDC.

However, in the time to digital converter described in International Publication No. 2013/034770, a reduction in conversion accuracy has occurred due to a code error of a connection between coarse TDC data and fine TDC data.

### SUMMARY OF THE INVENTION

The present invention in its first aspect provides a time to digital converter as specified in claims 1 to 12.

The present invention in its second aspect provides a distance measuring apparatus as specified in claims 13 to 17.

The present invention in its third aspect provides a moving object as specified in claim 18.

The present invention in its fourth aspect provides an equipment as specified in claim 19.

According to the aspect of the present invention, it becomes possible to realize highly accurate time to digital conversion.

Further features of the present invention will become apparent from the following description of exemplary embodiments with reference to the attached drawings.

### BRIEF DESCRIPTION OF THE DRAWINGS

Fig. 1 is a block diagram for describing a distance image sensor system according to a first embodiment.
Fig. 2 is a block diagram for describing a distance image sensor according to the first embodiment.
Fig. 3 is a circuit diagram for describing a pixel according to the first embodiment.
Fig. 4 is a block diagram for describing a time to digital converter according to the first embodiment.
Fig. 5 is a circuit diagram for describing the time to digital converter according to the first embodiment.
Fig. 6 is a drive timing chart for describing the distance image sensor according to the first embodiment.
Fig. 7 is a drive timing chart for describing the time to digital converter according to the first embodiment.
Fig. 8 is a drive timing chart for describing the time to digital converter according to the first embodiment.
Fig. 9 is a drive timing chart for describing the time to digital converter according to the first embodiment.
Fig. 10 is a block diagram for describing the time to digital converter according to a reference example.
Fig. 11 is a drive timing chart for describing the time to digital converter according to the reference example.
Fig. 12A is a diagram for describing signal processing of the time to digital converter according to the first embodiment.
Fig. 12B is a diagram for describing the signal processing of the time to digital converter according to the reference example.
Fig. 13 is a block diagram for describing the time to digital converter according to a second embodiment.
Fig. 14 is a circuit diagram for describing the time to digital converter according to the second embodiment.
Fig. 15A is a schematic diagram for describing an equipment according to a third embodiment.
Fig. 15B is a schematic diagram for describing the equipment according to the third embodiment.
Fig. 15C is a schematic diagram for describing the equipment according to the third embodiment.

### DESCRIPTION OF THE EMBODIMENTS

Hereinafter, each of the embodiments will be described with reference to the drawings. It is noted that the following embodiments are not intended to limit the invention related to a scope of claims. Multiple features are described in the embodiments, but not all these multiple features are necessarily indispensable to the invention, and multiple features may be optionally combined. Furthermore, in the accompanying drawings, the same reference signs are assigned to the same or similar components, and duplicated descriptions are omitted. Each of the embodiments of the present invention described below can be implemented solely or as a combination of a plurality of the embodiments or features thereof where necessary or where the combination of elements or features from individual embodiments in a single embodiment is beneficial.

In the present specification, terms that indicate specific directions or positions (for example, "up", "down", "right", and "left", and other terms that incorporate these terms) are used when necessary. The use of these terms is for a purpose for ease of understanding the embodiments with reference to the drawings, and a technical scope of the present invention is not limited by the meanings of these terms.

### First Embodiment

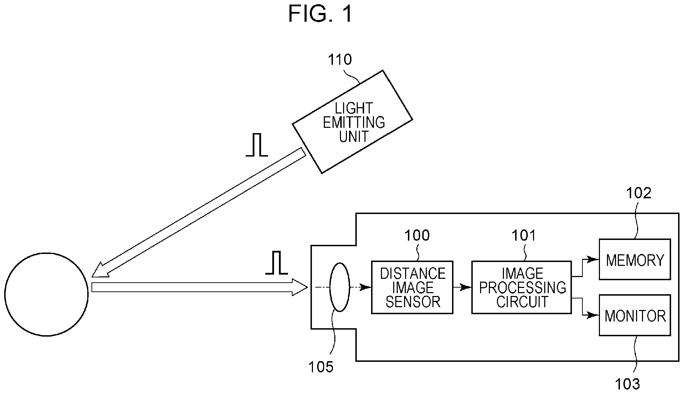

A distance image sensor system according to a first embodiment based on the present invention will be described with reference to Fig. 1.

Fig. 1 is an example of a block diagram of the distance image sensor system according to the present embodiment. A distance image sensor system serves as a distance measuring apparatus configured to measure a distance to a target object based on a time of flight (TOF) of light and includes a light emitting unit 110, an optical system 105, a distance image sensor 100, an image processing circuit 101, a memory 102, and a monitor 103.

The light emitting unit 110 can emit pulsed light such as laser towards the target object. The optical system 105 includes one or more lenses and forms an image of image light (incident light) reflected in the target object on a light receiving surface (light receiving unit) of the distance image sensor 100. The distance image sensor 100 includes a single photon avalanche diode (SPAD) configured to receive a single photon and a time to digital converter configured to convert a time interval from a light emission to a light reception into a digital signal. The image processing circuit 101 generates a distance image according to a distance to the target object based on time interval digital data output from the time to digital converter and the known speed of light. The generated distance image is input to the memory 102 and the monitor 103. The memory 102 can store the distance image, and the monitor 103 can display the distance image.

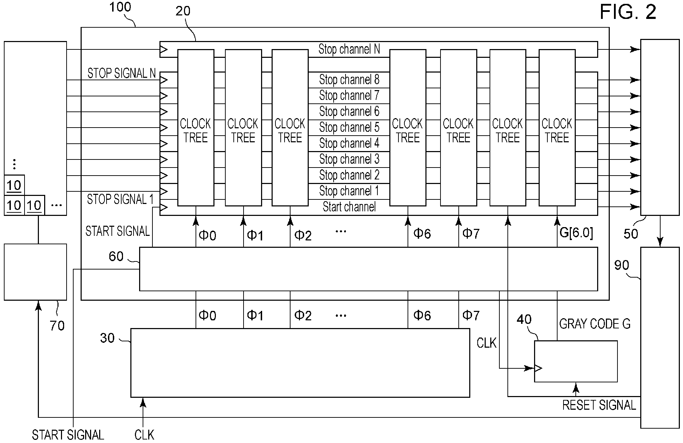

The distance image sensor according to the first embodiment based on the present invention will be described with reference to Fig. 2.

Fig. 2 is an example of a block diagram of the distance image sensor according to the present embodiment. The distance image sensor 100 includes a plurality of pixels 10 arranged across a plurality of rows and a plurality of columns, a time to digital converter (TDC) 20, a multiphase phase locked loop (PLL) circuit 30, and a Gray counter 40. The distance image sensor 100 also includes a buffer circuit 60, a vertical scanning circuit 70, a horizontal transfer circuit 50, and a digital processing circuit 90. The vertical scanning circuit 70 supplies a control pulse to each of the plurality of pixels. A logic circuit such as a shift register or an address decoder is used as the vertical scanning circuit 70. The horizontal transfer circuit 50 inputs a signal to the digital processing circuit 90 based on a signal output from the time to digital converter. The digital processing circuit 90 performs digital processing on a signal output from the horizontal transfer circuit 50. The TDC 20 converts a time interval from a light emission to a light reception into a digital signal based on signals from the plurality of pixels 10. The TDC 20 also corresponds to a Start channel and a Stop channel.

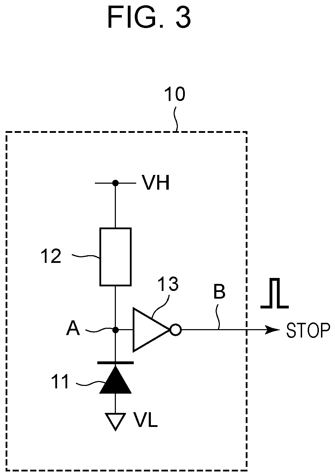

The pixel according to the first embodiment based on the present invention will be described with reference to Fig. 3.

Fig. 3 is an example of a circuit diagram of the pixel 10 according to the present embodiment. The pixel 10 includes a SPAD 11, a quench element 12, and a waveform shaping unit 13 and functions as a light receiving unit for pulsed light. The SPAD 11 generates a charge pair according to incident light by way of photoelectric conversion. A voltage VL (first voltage) is supplied to an anode of the SPAD 11, and a voltage VH (second voltage) which is higher than the voltage VL supplied to the anode is supplied to a cathode of the SPAD 11. A reverse bias voltage is applied to the anode and the cathode to put the SPAD 11 into a state in which an avalanche multiplication can be caused. When a photon is incident on the SPAD 11 in a state in which the reverse bias voltage is supplied, charge generated by the photon causes the avalanche multiplication to generate an avalanche current.

The quench element 12 is provided between a power source line through which the voltage VH is supplied and the cathode of the SPAD 11. The quench element 12 functions as a load circuit (quench circuit) when the signal is multiplied due to the avalanche multiplication and has a role (quench operation) to suppress the voltage to be supplied to the SPAD 11 to suppress the avalanche multiplication. The quench element 12 also has a role (charge operation) to set the voltage to be supplied to the SPAD 11 to be back to the voltage VH by causing a current corresponding to the voltage drop based on the quench operation to flow. The quench element 12 and the SPAD 11 are electrically connected at a node A. The quench element 12 may be set as a resistive element or may be set as a transistor including a gate to which a control signal is input. In a mode in which the quench element 12 is the transistor, during a period in which the transistor is turned off by the control signal, the charge operation is not performed. In this case, when the avalanche multiplication operation is performed, the voltage at the node A changes to a voltage at which the avalanche multiplication of the SPAD 11 stops. Thereafter, since the transistor turns on by the control signal, the voltage at the node A is charged to a voltage corresponding to the voltage VH. This control signal may be set as a clock pulse signal. It is noted that the quench element 12 may be configured to include a plurality of elements. For example, the quench element 12 may include an element configured to limit an amplitude at which the node A changes and an element configured to charge the node A.

The waveform shaping unit 13 functions as a signal generation unit configured to generate a detection pulse based on an output generated by the incidence of the photon. That is, the waveform shaping unit 13 shapes a potential change of the cathode of the SPAD 11 which is acquired at the time of photon detection to output a STOP signal (detection pulse) that is a rectangular wave. The waveform shaping unit 13 may be constituted by an inverter circuit, for example. Fig. 3 illustrates a single inverter circuit, but a circuit using a plurality of serially connected inverter circuits may be used. Other circuits with a waveform shaping effect may also be used.

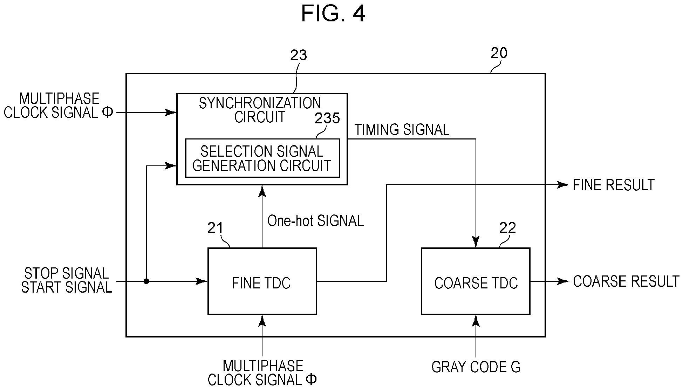

The TDC 20 according to the first embodiment based on the present invention will be described with reference to Fig. 4 to Fig. 8.

Fig. 4 is an example of a block diagram of the TDC 20 according to the present embodiment. The TDC 20 may be provided for each row of the pixels 10, and the pixels 10 on each column may be sequentially connected to the TDC 20. The TDC 20 includes a fine TDC 21, a coarse TDC 22, and a synchronization circuit 23. It is noted that in the following descriptions, the fine TDC 21 may be referred to as a first circuit, the coarse TDC 22 may be referred to as a second circuit, and the synchronization circuit 23 may be referred to as a third circuit. It is noted that the TDC 20 may be provided to each of the pixels 10 (each of the light receiving units). It is noted that the TDC 20 may be provided for each subarray including the plurality of pixels 10.

A START signal, a STOP signal, and a multiphase clock signal Φ are input to the fine TDC 21. The START signal is a signal synchronized with a timing (first timing) at which the light emitting unit 110 has emitted light in Fig. 1. The TDC 20 starts timekeeping in response to the START signal. The STOP signal is a signal output from the pixel 10. That is, the STOP signal represents a timing (second timing) at which the pulsed light emitted from the light emitting unit 110 and reflected in the target object has been received by the pixel 10. The TDC 20 outputs time interval digital data having multiple bits according to a time interval from the first timing to the second timing. That is, the TDC 20 can convert a time interval from the START signal to the STOP signal into a digital signal. The multiphase clock signal Φ is a clock signal output from the multiphase PLL circuit 30. The fine TDC 21 generates lower order bits (fine result) based on the START signal, the STOP signal, and the multiphase clock signal Φ which have been input. The fine TDC 21 also generates a One-hot signal (first signal) based on the START signal, the STOP signal, and the multiphase clock signal Φ which have been input. The One-hot signal generated by using a signal with multiple bits among the lower order bits is a 4-bit signal that is a bit string in which only one bit is a high level (1) and the other bits are a low level (0). It is noted that herein, as an example, the One-hot signal is set as a 4-bit signal, but there is no particular restriction on the number of bits.

It is noted that hereinafter, in a case where the multiphase clock signals Φ need to be differentiated from each other, an identification number (0, 1, 2, ..., 7) is appended at the end of the reference sign for the component of the multiphase clock signal Φ. However, in a case where the multiphase clock signals Φ do not need to be differentiated from each other, the identification number at the end of the reference sign for the component of the multiphase clock signal Φ is omitted.

A timing signal (second signal) and a Gray code G are input to the coarse TDC 22.

The timing signal is a signal output from the synchronization circuit 23. The Gray code G is a signal output from the Gray counter 40. The Gray code G is set such that a bit change occurs at only one bit in adjacent values in binary representation. The coarse TDC 22 generates higher order bits (coarse result) based on the timing signal and the Gray code G which have been input.

The START signal, the STOP signal, the multiphase clock signal Φ, and the One-hot signal are input to the synchronization circuit 23. The One-hot signal is a signal output from the fine TDC 21. The synchronization circuit 23 generates the timing signal based on the START signal, the STOP signal, the multiphase clock signal Φ, and the One-hot signal which have been input. The synchronization circuit 23 outputs the timing signal to the coarse TDC 22 to synchronize the fine TDC 21 and the coarse TDC 22.

It is noted that hereinafter, in a case where the Gray codes G need to be differentiated from each other, an identification number (0, 1, 2, ..., 5) is appended at the end of the reference sign for the component of the Gray code G. However, in a case where the Gray codes G do not need to be differentiated from each other, the identification number at the end of the reference sign for the component of the Gray code G is omitted.

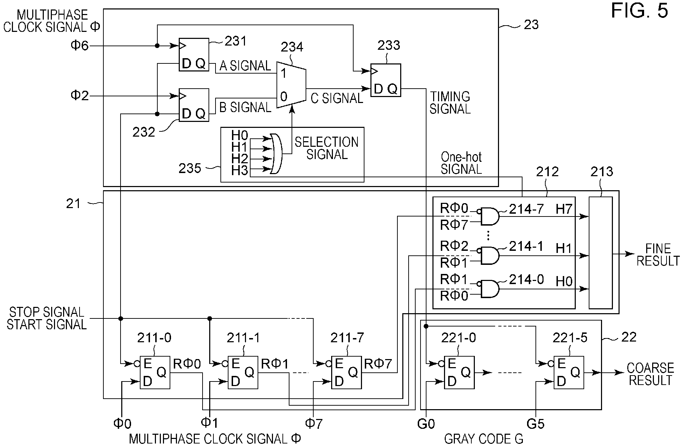

Fig. 5 is an example of a circuit diagram of the TDC 20 according to the present embodiment. The fine TDC 21 includes a plurality of latch circuits 211, a differentiation circuit 212, and an encoder 213. The plurality of latch circuits 211 are of D type. It is noted that the plurality of D-type latch circuits 211 may be a plurality of D-type flip-flop circuits. It is noted that the fine TDC 21 may include a plurality of D-type latch circuits 221 and a plurality of D-type flip-flop circuits. The START signal or the STOP signal is input to the inverting input nodes E (first input nodes) of the plurality of latch circuits 211, and the multiphase clock signal Φ is input to the input nodes D (second input nodes) of the plurality of latch circuits 211. In Fig. 5, as the multiphase clock signal Φ, for example, the multiphase clock signals Φ0 to Φ7 with different phases are respectively input to the plurality of corresponding latch circuits 211-0 to 211-7. That is, the multiphase clock signal Φ0 is input to the latch circuit 211-0, the multiphase clock signal Φ1 is input to the latch circuit 211-1, the multiphase clock signal Φ2 is input to the latch circuit 211-2, and the multiphase clock signal Φ3 is input to the latch circuit 211-3. The multiphase clock signal Φ4 is input to the latch circuit 211-4, the multiphase clock signal Φ5 is input to the latch circuit 211-5, the multiphase clock signal Φ6 is input to the latch circuit 211-6, and the multiphase clock signal Φ7 is input to the latch circuit 211-7. It is noted that the multiphase clock signals Φ1 to Φ7 have phases shifted in the stated order from the multiphase clock signal Φ0 to the multiphase clock signal Φ7, and a phase difference between clock signals with adjacent numbers is a predetermined amount "a". Output nodes of the plurality of latch circuits 211 are connected to the differentiation circuit 212 configured to perform differentiation processing. The differentiation circuit 212 includes a plurality of gate circuits 214, and the output nodes of the plurality of latch circuits 211 are connected to inverting input nodes or non-inverting input nodes of the plurality of gate circuits 214. That is, the output node of the latch circuit 211-0 is connected to the non-inverting input node of the gate circuit 214-0, and the output node of the latch circuit 211-1 is connected to the inverting input node of the gate circuit 214-0. The output node of the latch circuit 211-1 is connected to the non-inverting input node of the gate circuit 214-1, and the output node of the latch circuit 211-2 is connected to the inverting input node of the gate circuit 214-1. The output node of the latch circuit 211-2 is connected to the non-inverting input node of the gate circuit 214-2, and the output node of the latch circuit 211-3 is connected to the inverting input node of the gate circuit 214-2. The output node of the latch circuit 211-3 is connected to the non-inverting input node of the gate circuit 214-3, and the output node of the latch circuit 211-4 is connected to the inverting input node of the gate circuit 214-3. The output node of the latch circuit 211-4 is connected to the non-inverting input node of the gate circuit 214-4, and the output node of the latch circuit 211-5 is connected to the inverting input node of the gate circuit 214-4. The output node of the latch circuit 211-5 is connected to the non-inverting input node of the gate circuit 214-5, and the output node of the latch circuit 211-6 is connected to the inverting input node of the gate circuit 214-5. The output node of the latch circuit 211-6 is connected to the non-inverting input node of the gate circuit 214-6, and the output node of the latch circuit 211-7 is connected to the inverting input node of the gate circuit 214-6. The output node of the latch circuit 211-7 is connected to the non-inverting input node of the gate circuit 214-7, and the output node of the latch circuit 211-0 is connected to the inverting input node of the gate circuit 214-7. Output nodes of the plurality of gate circuits 214 are connected to the synchronization circuit 23 and the encoder 213. Then, signals output from the output nodes of the plurality of gate circuits 214 are input to the synchronization circuit 23 as the One-hot signals. A signal H0 output from the gate circuit 214-0, a signal H1 output from the gate circuit 214-1, a signal H2 output from the gate circuit 214-2, and a signal H3 output from the gate circuit 214-3 are input to the encoder 213. A signal H4 output from the gate circuit 214-4, a signal H5 output from the gate circuit 214-5, a signal H6 output from the gate circuit 214-6, and a signal H7 output from the gate circuit 214-7 are also input to the encoder 213. The encoder 213 encodes the signals output from the output nodes of the plurality of gate circuits 214 to output a binary code signal (fine result).

It is noted that hereinafter, in a case where the plurality of latch circuits 211 need to be differentiated from each other, an identification number (0, 1, 2, ..., 7) is appended at the end of the reference sign for the component of the latch circuit 211. However, in a case where the plurality of latch circuits 211 do not need to be differentiated from each other, the identification number at the end of the reference sign for the component of the latch circuit 211 is omitted. It is noted that hereinafter, in a case where the plurality of gate circuits 214 need to be differentiated from each other, an identification number (0, 1, 2, ..., 7) is appended at the end of the reference sign for the component of the gate circuit 214. However, in a case where the plurality of gate circuits 214 do not need to be differentiated from each other, the identification number at the end of the reference sign for the component of the gate circuit 214 is omitted.

The coarse TDC 22 includes a plurality of latch circuits 221. The plurality of latch circuits 221 are of D type. It is noted that the plurality of D-type latch circuits 221 may be a plurality of D-type flip-flop circuits. Note also that the coarse TDC 22 may include a plurality of D-type latch circuits 221 and a plurality of D-type flip-flop circuits. The timing signal is input to inverting input nodes E (first input nodes) of the plurality of latch circuits 221, and the Gray code G is input to input nodes D (second input nodes) of the plurality of latch circuits 221. Signals output from the plurality of latch circuits 221 are output as the coarse result.

It is noted that hereinafter, in a case where the plurality of latch circuits 221 need to be differentiated from each other, an identification number (0, 1, 2, ..., 7) is appended at the end of the reference sign for the component of the latch circuit 221. However, in a case where the plurality of latch circuits 221 do not need to be differentiated from each other, the identification number at the end of the reference sign for the component of the latch circuit 221 is omitted.

The synchronization circuit 23 includes a first flip-flop circuit 231, a second flip-flop circuit 232, a third flip-flop circuit 233, a multiplexer (selection circuit) 234, and a selection signal generation circuit 235. The first flip-flop circuit 231, the second flip-flop circuit 232, and the third flip-flop circuit 233 are of D type. It is noted that the first flip-flop circuit 231, the second flip-flop circuit 232, and the third flip-flop circuit 233 may be a D-type latch circuit. Note also that the synchronization circuit 23 may include a plurality of flip-flop circuits and a plurality of latch circuits. The START signal or the STOP signal is input to the input nodes D (first input nodes) of the first flip-flop circuit 231 and the second flip-flop circuit 232. The multiphase clock signal Φ is input to clock nodes (second input nodes) of the first flip-flop circuit 231 and the second flip-flop circuit 232. In Fig. 5, as the multiphase clock signal Φ, for example, the multiphase clock signal Φ6 is input to the first flip-flop circuit 231, and the multiphase clock signal Φ2 is input to the second flip-flop circuit 232 among the multiphase clock signals Φ1 to Φ7 with different phases. It is noted that a phase difference between the phase of the multiphase clock signal Φ2 and the phase of the multiphase clock signal Φ6 is set as a half of a period. An output node of the first flip-flop circuit 231 is connected to an input node 1 of the multiplexer 234, and an output node of the second flip-flop circuit 232 is connected to an input node 0 of the multiplexer 234. A signal output by the first flip-flop circuit 231 is set as an A signal. A signal output by the second flip-flop circuit 232 is set as a B signal. The output nodes of the gate circuit 214-0, 214-1, 214-2, and 214-3 are connected to a plurality of input nodes of the selection signal generation circuit 235. The signals output from the respective output nodes are input to the plurality of input nodes of the selection signal generation circuit 235 as the One-hot signals. For example, the signal H0, the signal H1, the signal H2, and the signal H3 are input to the selection signal generation circuit 235. An output node of the selection signal generation circuit 235 is connected to the multiplexer 234, and the selection signal generation circuit 235 outputs a selection signal. An output node of the multiplexer 234 is connected to an input node D of the third flip-flop circuit 233. A signal output by the multiplexer 234 is set as a C signal. The multiplexer 234 outputs the C signal generated by using the A signal or the B signal to the third flip-flop circuit 233 based on the selection signal. That is, the multiplexer 234 selects one signal out of the A signal or the B signal and outputs the selected signal as the C signal. The C signal output from the multiplexer 234 is input to the input node D of the third flip-flop circuit 233, and the multiphase clock signal Φ is input to a clock node of the third flip-flop circuit 233. In Fig. 5, as the multiphase clock signal Φ, for example, the multiphase clock signal Φ6 that has been input to the first flip-flop circuit 231 is also input to the third flip-flop circuit 233. An output node of the third flip-flop circuit 233 is connected to the inverting input nodes E of the plurality of latch circuits 221 included in the coarse TDC 22. The timing signal output from the third flip-flop circuit 233 is input to the plurality of latch circuits 221.

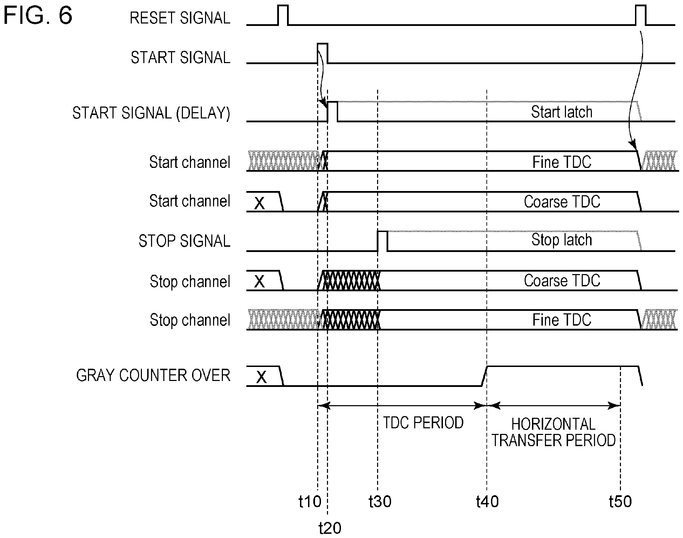

Fig. 6 is an example of a drive timing chart diagram of the distance image sensor according to the present embodiment.

It is noted that since an operational delay may occur in an actual circuit, in the drive timing chart diagram of Fig. 6, a START signal that takes into account the operational delay in the circuit is denoted as a START signal (delay).

At a time instant t10, the START signal transitions from the low level to the high level (first timing). However, due to an influence from the operational delay in the circuit, in actuality, the light emitting unit 110 does not emit the pulsed light towards the target object at the time instant t10. At a time instant t20, the START signal (delay) transitions from the low level to the high level, and the light emitting unit 110 emits the pulsed light towards the target object. At a time instant t30, the pixel 10 detects the pulsed light reflected in the target object to output the STOP signal (second timing).

The fine TDC 21 corresponding to the Start channel and the coarse TDC 22 corresponding to the Start channel perform time to digital conversion of a time interval from the time instant t10 to the time instant t20 to output a digital signal A. The fine TDC 21 corresponding to the Stop channel and the coarse TDC 22 corresponding to the Stop channel perform time to digital conversion of a time interval from the time instant t10 to the time instant t30 to output a digital signal B. A digital signal C acquired by subtracting the digital signal A output from the fine TDC 21 corresponding to the Start channel from the digital signal B output from the fine TDC 21 corresponding to the Stop channel is generated. A digital signal D acquired by subtracting the digital signal A output from the coarse TDC 22 corresponding to the Start channel from the digital signal B output from the coarse TDC 22 corresponding to the Stop channel is generated. A digital signal acquired by combining the digital signal C and the digital signal D is a digital signal corresponding to a time interval from the light emission to the light reception.

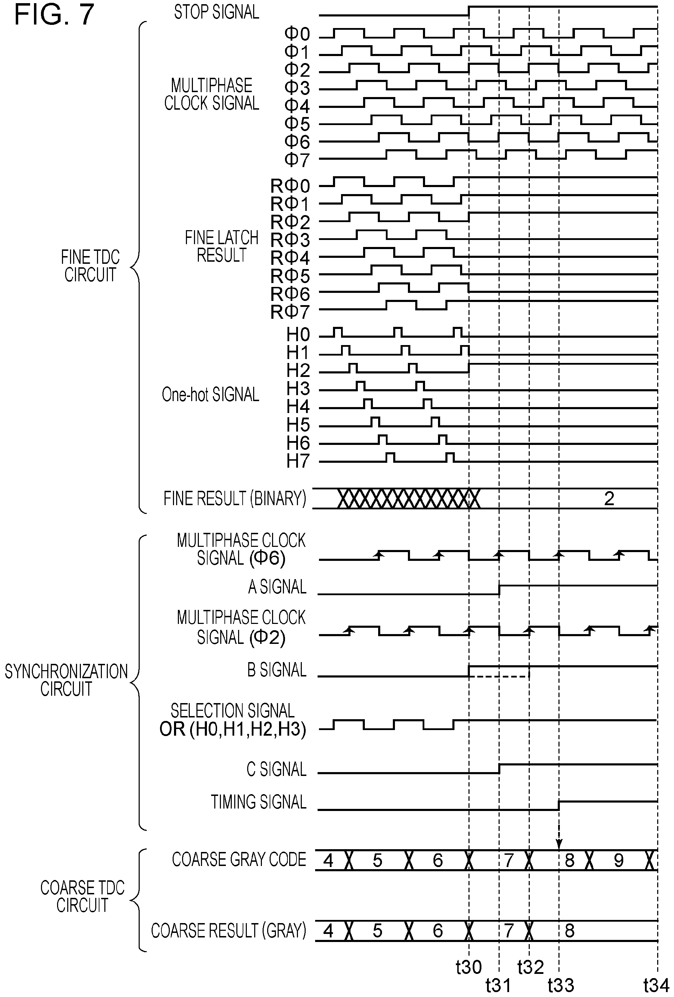

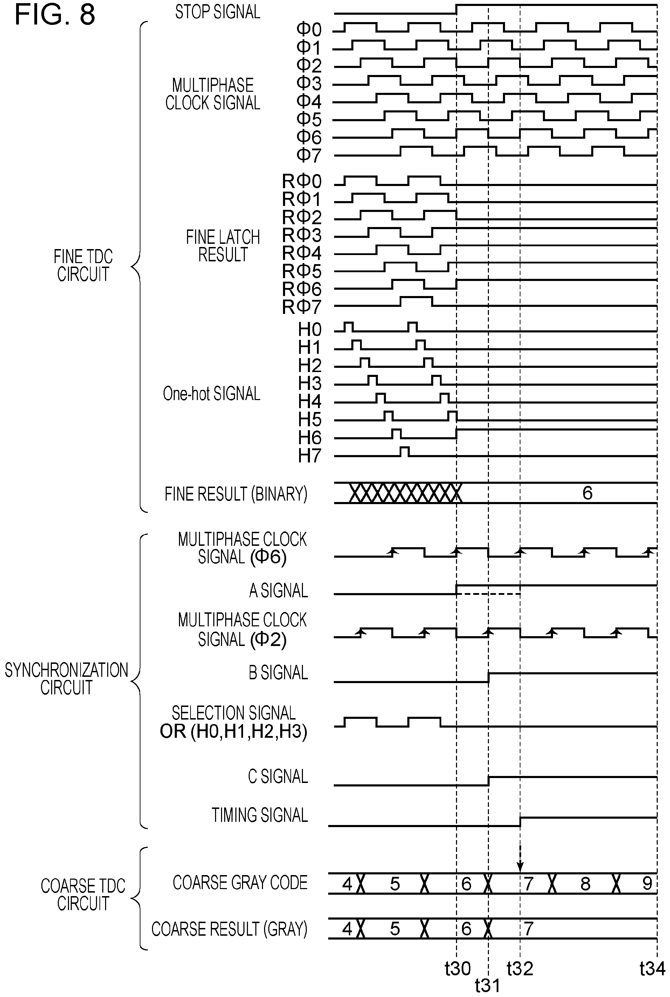

Fig. 7 and Fig. 8 are examples of the drive timing chart diagram of the TDC 20 corresponding to the Stop channel according to the present embodiment. It is noted that Fig. 7 and Fig. 8 illustrate examples in which the timing for the STOP signal to transition from the low level to the high level varies and the phase of the multiphase clock signal Φ varies.

In Fig. 7 and Fig. 8, at the time instant t30, the STOP signal transitions from the low level to the high level, and the STOP signal transitions from the high level to the low level at a time instant t34 and the subsequent time.

The STOP signal is input to the inverting input nodes E of the plurality of latch circuits 211, and the multiphase clock signal Φ is input to the input nodes D of the plurality of latch circuits 211. As a result, during at least a period from the time instant t30 to the time instant t34, the plurality of latch circuits 211 output the level (for example, the low level or the high level) of the multiphase clock signal Φ that has been input to the input node D at the time instant t30.

The plurality of gate circuits 214 output the signal at the high level in a case where the signal input to the inverting input node is the low level and the signal input to the non-inverting input node is the high level. On the other hand, the plurality of gate circuits 214 output the signal at the low level in a case where the signal input to the inverting input node is the high level or a case where the signal input to the non-inverting input node is the low level.

The selection signal generation circuit 235 outputs, as the selection signal, a result of an OR operation using the signals respectively output from the gate circuits 214-0, 214-1, 214-2, and 214-3.

The STOP signal is input to the input nodes D of the first flip-flop circuit 231 and the second flip-flop circuit 232. The multiphase clock signal Φ6 is input to the clock node of the first flip-flop circuit 231. The multiphase clock signal Φ2 is input to the clock node of the second flip-flop circuit 232. As a result, during the period from the time instant t30 to the time instant t34, before the multiphase clock signal Φ6 transitions from the low level to the high level, the first flip-flop circuit 231 outputs the signal at the low level as the A signal. During the period from the time instant t30 to the time instant t34, after the multiphase clock signal Φ6 has transitioned from the low level to the high level, the first flip-flop circuit 231 outputs the signal at the high level as the A signal. During the period from the time instant t30 to the time instant t34, before the multiphase clock signal Φ2 transitions from the low level to the high level, the second flip-flop circuit 232 outputs the signal at the low level as the B signal. During the period from the time instant t30 to the time instant t34, after the multiphase clock signal Φ2 has transitioned from the low level to the high level, the second flip-flop circuit 232 outputs the signal at the high level as the B signal.

The A signal is input to the input node 1 of the multiplexer 234, and the B signal is input to the input node 0 of the multiplexer 234. The multiplexer 234 outputs either the A signal or the B signal as the C signal based on the selection signal. For example, the multiplexer 234 outputs the A signal as the C signal in a case where the selection signal is the high level and outputs the B signal as the C signal in a case where the selection signal is the low level.

The C signal is input to the input node D of the third flip-flop circuit 233, and the multiphase clock signal Φ6 is input to the clock node of the third flip-flop circuit 233. As a result, during the period from the time instant t30 to the time instant t34, the third flip-flop circuit 233 outputs the C signal at a point in time when the multiphase clock signal Φ6 transitions from the low level to the high level as the timing signal.

The timing signal is input to the inverting input nodes E of the plurality of latch circuits 221, and the Gray code G is input to the input nodes D of the plurality of latch circuits 221. As a result, during the period from the time instant t30 to the time instant t34, the plurality of latch circuits 221 output the level of the Gray code G input to the input node D after the timing signal input to the inverting input node E has transitioned to the high level.

In accordance with the above-described drive, the fine TDC 21 outputs a fine result corresponding to the lower order bits based on the signals output from the plurality of gate circuits 214. The coarse TDC 22 outputs a coarse result corresponding to the higher order bits based on the signals output from the plurality of latch circuits 221.

In Fig. 7, at the time instant t30, the multiphase clock signals Φ0, Φ1, and Φ7 are the high level, and the multiphase clock signals Φ3 to Φ5 are the low level. In addition, at the time instant t30, the multiphase clock signal Φ2 transitions from the low level to the high level, and the multiphase clock signal Φ6 transitions from the high level to the low level. As a result, in response to the transition of the STOP signal from the low level to the high level, the latch circuits 211-0 to 211-2 and 211-7 output the signal at the high level, and the latch circuits 211-3 to 211-6 output the signal at the low level. Then, based on the signals output from the plurality of latch circuits 211, the gate circuit 214-2 outputs the signal at the high level, and the gate circuits 214-0, 214-1, and 214-3 to 214-7 output the signal at the low level. The encoder 213 confirms "2", for example, as the lower order bits based on the signal at the high level output from the gate circuit 214-2. It is noted that in the present specification, a value of the lower order bits is expressed in decimal for convenience, but in reality, a signal expressed in binary is held.

At the time instant t30, since it is before the input multiphase clock signal Φ6 transitions from the low level to the high level, the first flip-flop circuit 231 outputs the signal at the low level as the A signal. In addition, at the time instant t30, since the input multiphase clock signal Φ2 transitions from the low level to the high level, the second flip-flop circuit 232 outputs the signal at the high level as the B signal. Since the signal at the high level is input from the gate circuit 214-2, the selection signal generation circuit 235 outputs the signal at the high level as the selection signal. Since the signal at the high level is input as the selection signal, the multiplexer 234 outputs the A signal, that is, the signal at the low level as the C signal. Since the signal at the low level is input as the C signal, the third flip-flop circuit 233 outputs the signal at the low level as the timing signal.

At a time instant t31, the multiphase clock signal Φ6 transitions from the low level to the high level, and the multiphase clock signal Φ2 transitions from the high level to the low level. Since the input multiphase clock signal Φ6 transitions from the low level to the high level, the first flip-flop circuit 231 outputs the signal at the high level as the A signal. The second flip-flop circuit 232 continuously outputs the signal at the high level as the B signal from the time instant t30. Since the signal at the high level is continuously input from the gate circuit 214-2 from the time instant t30, the selection signal generation circuit 235 outputs the signal at the high level as the selection signal. Since the signal at the high level is input as the selection signal from the time instant t30, the multiplexer 234 outputs the A signal, that is, the signal at the high level as the C signal. Herein, whereas the first flip-flop circuit 231 and the second flip-flop circuit 232 are provided in a first stage, the third flip-flop circuit 233 is provided in a second stage. As a result, in response to the transition of the multiphase clock signal Φ6 from the low level to the high level, the A signal output from the first flip-flop circuit 231 is input to the third flip-flop circuit 233 as the C signal via the multiplexer 234. That is, an output result of the first flip-flop circuit 231 is input to the third flip-flop circuit 233 while being affected by the signal delay due to the intermediation of the multiplexer 234. Thus, after the multiphase clock signal Φ6 has transitioned from the low level to the high level, the signal at the high level is input to the third flip-flop circuit 233 as the C signal. As a result, the third flip-flop circuit 233 outputs the signal at the low level as the timing signal based on the C signal at the low level which is input at a point in time when the multiphase clock signal Φ6 has transitioned from the low level to the high level.

At a time instant t32, the multiphase clock signal Φ6 transitions from the high level to the low level, and the multiphase clock signal Φ2 transitions from the low level to the high level. The first flip-flop circuit 231 continuously outputs the signal at the high level as the A signal from the time instant t31. The second flip-flop circuit 232 continuously outputs the signal at the high level as the B signal from the time instant t30. Since the signal at the high level is continuously input from the gate circuit 214-2 from the time instant t30, the selection signal generation circuit 235 outputs the signal at the high level as the selection signal. Since the signal at the high level is input as the selection signal from the time instant t30, the multiplexer 234 outputs the A signal, that is, the signal at the high level as the C signal.

Although the signal at the high level is input as the C signal, since it is before the input multiphase clock signal Φ6 transitions from the low level to the high level, the third flip-flop circuit 233 outputs the signal at the low level as the timing signal.

At a time instant t33, the multiphase clock signal Φ6 transitions from the low level to the high level, and the multiphase clock signal Φ2 transitions from the high level to the low level. The first flip-flop circuit 231 continuously outputs the signal at the high level as the A signal from the time instant t31. The second flip-flop circuit 232 continuously outputs the signal at the high level as the B signal from the time instant t30. Since the signal at the high level is continuously input from the gate circuit 214-2 from the time instant t30, the selection signal generation circuit 235 outputs the signal at the high level as the selection signal. Since the signal at the high level is input as the selection signal from the time instant t30, the multiplexer 234 outputs the A signal, that is, the signal at the high level as the C signal.

Since the signal at the high level is input as the C signal, in response to the transition of the input multiphase clock signal Φ6 from the low level to the high level, the third flip-flop circuit 233 outputs the signal at the high level as the timing signal. Furthermore, for example, "8" is confirmed as the higher order bits based on the signal at the high level which has been output as the timing signal and on the Gray code G. It is noted that in the present specification, a value of the higher order bits is also expressed in decimal for convenience similarly as in the lower order bit, but in reality, a signal expressed in binary is held.

It is noted that at the time instant t30, the STOP signal transitions from the low level to the high level, and the multiphase clock signal Φ2 transitions from the low level to the high level, but the second flip-flop circuit 232 may output the signal at the low level as the B signal. This situation is based on a state in which the second flip-flop circuit 232 does not normally function as the flip-flop circuit due to a performance limitation in a case where timings at which two signals to be input transition from the low level to the high level are close to each other. In addition, at the time instant t30, after the multiphase clock signal Φ2 has transitioned from the low level to the high level, the STOP signal may transition from the low level to the high level, and the second flip-flop circuit 232 may output the signal at the low level as the B signal.

This situation is based on an operational delay of the circuit configured to generate the STOP signal or the circuit configured to transmit the STOP signal. However, according to the present embodiment, the higher order bits are generated without using the B signal the signal level of which may not be stable as described above, so that the highly accurate time to digital conversion can be performed.

In Fig. 8, at the time instant t30, the multiphase clock signals Φ3 to Φ5 are the high level, and the multiphase clock signals Φ0, Φ1, and Φ7 are the low level. In addition, at the time instant t30, the multiphase clock signal Φ2 transitions from the high level to the low level, and the multiphase clock signal Φ6 transitions from the low level to the high level. As a result, in response to the transition of the STOP signal from the low level to the high level, the latch circuits 211-3 to 211-6 output the signal at the high level, and the latch circuits 211-0 to 211-2 and 211-7 output the signal at the low level. Then, based on the signals output from the plurality of latch circuits 211, the gate circuit 214-6 outputs the signal at the high level, and the gate circuits 214-0 to 214-5 and 214-7 output the signal at the low level. The encoder 213 confirms "6", for example, as the lower order bits based on the signal at the high level which has been output from the gate circuit 214-6. It is noted that in the present specification, a value of the lower order bits is expressed in decimal for convenience, but in reality, a signal expressed in binary is held.

At the time instant t30, since the input multiphase clock signal Φ6 transitions from the low level to the high level, the first flip-flop circuit 231 outputs the signal at the high level as the A signal. In addition, at the time instant t30, since it is before the input multiphase clock signal Φ2 transitions from the low level to the high level, the second flip-flop circuit 232 outputs the signal at the low level as the B signal. Since the signal at the low level is input from the gate circuits 214-0 to 214-3, the selection signal generation circuit 235 outputs the signal at the low level as the selection signal. Since the signal at the low level is input as the selection signal, the multiplexer 234 outputs the B signal, that is, the signal at the low level as the C signal. Since the signal at the low level is input as the C signal, the third flip-flop circuit 233 outputs the signal at the low level as the timing signal.

At the time instant t31, the multiphase clock signal Φ6 transitions from the high level to the low level, and the multiphase clock signal Φ2 transitions from the low level to the high level. The first flip-flop circuit 231 continuously outputs the signal at the high level as the A signal from the time instant t30. Since the input multiphase clock signal Φ2 transitions from the low level to the high level, the second flip-flop circuit 232 outputs the signal at the high level as the B signal. Since the signal at the low level is continuously input from the gate circuits 214-0 to 214-3 from the time instant t30, the selection signal generation circuit 235 outputs the signal at the low level as the selection signal. Since the signal at the low level is input from the time instant t30 as the selection signal, the multiplexer 234 outputs the B signal, that is, the signal at the high level as the C signal. Although the signal at the high level is input as the C signal, since it is before the input multiphase clock signal Φ6 transitions from the low level to the high level, the third flip-flop circuit 233 outputs the signal at the low level as the timing signal.

At the time instant t32, the multiphase clock signal Φ6 transitions from the low level to the high level, and the multiphase clock signal Φ2 transitions from the high level to the low level. The first flip-flop circuit 231 continuously outputs the signal at the high level as the A signal from the time instant t30. The second flip-flop circuit 232 continuously outputs the signal at the high level as the B signal from the time instant t31. Since the signal at the low level is continuously input from the gate circuits 214-0 to 214-3 from the time instant t30, the selection signal generation circuit 235 outputs the signal at the low level as the selection signal. Since the signal at the low level is input from the time instant t30 as the selection signal, the multiplexer 234 outputs the B signal, that is, the signal at the high level as the C signal. Since the signal at the high level is input as the C signal, in response to the transition of the input multiphase clock signal Φ6 from the low level to the high level, the third flip-flop circuit 233 outputs the signal at the high level as the timing signal. Furthermore, for example, "7" is confirmed as the higher order bits based on the signal at the high level which has been output as the timing signal and on the Gray code G. It is noted that in the present specification, a value of the higher order bits is also expressed in decimal for convenience similarly as in the lower order bit, but in reality, a signal expressed in binary is held.

It is noted that at the time instant t30, the STOP signal transitions from the low level to the high level, and the multiphase clock signal Φ6 transitions from the low level to the high level, but the first flip-flop circuit 231 may output the signal at the low level as the A signal. This situation is based on a state in which the first flip-flop circuit 231 does not normally function as the flip-flop circuit due to a performance limitation in a case where timings at which two signals to be input transition from the low level to the high level are close to each other. In addition, at the time instant t30, after the multiphase clock signal Φ6 has transitioned from the low level to the high level, the STOP signal may transition from the low level to the high level, and the first flip-flop circuit 231 may output the signal at the low level as the A signal.

This situation is based on an operational delay of the circuit configured to generate the STOP signal or the circuit configured to transmit the STOP signal. However, according to the present embodiment, the higher order bits are generated without using the A signal the signal level of which may not be stable as described above, so that the highly accurate time to digital conversion can be performed.

Thus, according to the present embodiment, even in a case where the timing at which the STOP signal transitions from the low level to the high level is close to the timing at which the multiphase clock signal Φ transitions from the low level to the high level or a case where the operational delay in the circuit occurs, it is possible to realize the highly accurate time to digital conversion.

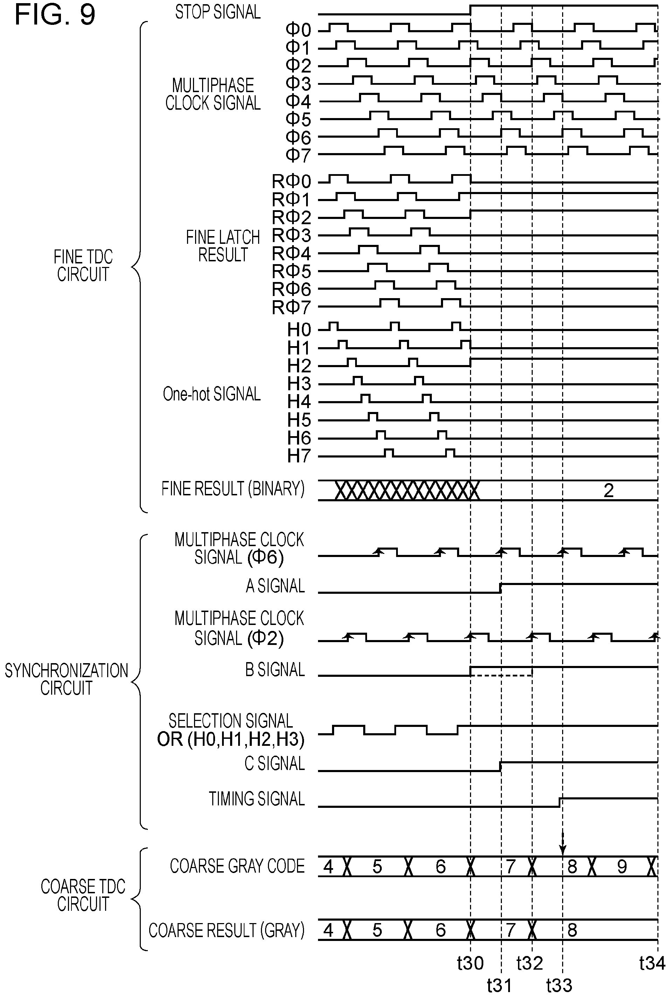

Fig. 9 is an example of the drive timing chart diagram of the TDC 20 corresponding to the Stop channel according to the present embodiment. Fig. 9 illustrates a case where, for example, a signal quality of the multiphase clock signal Φ has degraded due to a degradation or the like of a duty ratio of the multiphase clock signal Φ in Fig. 7. For example, in Fig. 9, a falling timing of the multiphase clock signal Φ is earlier than that of Fig. 7, and a proportion of the multiphase clock signals Φ which are the signals at the low level increases.

In Fig. 9, at the time instant t30, the STOP signal transitions from the low level to the high level, and at the time instant t34 and the subsequent time, the STOP signal transitions from the high level to the low level. At the time instant t30, the multiphase clock signal Φ1 is the high level, the multiphase clock signals Φ3 to Φ7 are the low level, the multiphase clock signal Φ0 transitions from the high level to the low level, and the multiphase clock signal Φ2 transitions from the low level to the high level. As a result, in response to the transition of the STOP signal from the low level to the high level, the latch circuits 211-1 and 211-2 output the signal at the high level, and the latch circuits 211-0 and 211-3 to 211-7 output the signal at the low level. Then, based on the signals output from the plurality of latch circuits 211, the gate circuit 214-2 outputs the signal at the high level, and the gate circuits 214-0, 214-1, and 214-3 to 214-7 output the signal at the low level. The encoder 213 confirms "2", for example, as the lower order bits based on the signal at the high level output from the gate circuit 214-2. It is noted that in the present specification, a value of the lower order bits is expressed in decimal for convenience, but in reality, a signal expressed in binary is held.

At the time instant t30, since it is before the input multiphase clock signal Φ6 transitions from the low level to the high level, the first flip-flop circuit 231 outputs the signal at the low level as the A signal. In addition, at the time instant t30, since the input multiphase clock signal Φ2 transitions from the low level to the high level, the second flip-flop circuit 232 outputs the signal at the high level as the B signal. Since the signal at the high level is input from the gate circuit 214-2, the selection signal generation circuit 235 outputs the signal at the high level as the selection signal. Since the signal at the high level is input as the selection signal, the multiplexer 234 outputs the A signal, that is, the signal at the low level as the C signal. Since the signal at the low level is input as the C signal, the third flip-flop circuit 233 outputs the signal at the low level as the timing signal.

During a period from the time instant t30 to the time instant t31, the multiphase clock signal Φ2 transitions from the high level to the low level, and at the time instant t31, the multiphase clock signal Φ6 transitions from the low level to the high level. Since the input multiphase clock signal Φ6 transitions from the low level to the high level, the first flip-flop circuit 231 outputs the signal at the high level as the A signal. The second flip-flop circuit 232 continuously outputs the signal at the high level as the B signal from the time instant t30. Since the signal at the high level is continuously input from the gate circuit 214-2 from the time instant t30, the selection signal generation circuit 235 outputs the signal at the high level as the selection signal. Since the signal at the high level is input as the selection signal from the time instant t30, the multiplexer 234 outputs the A signal, that is, the signal at the high level as the C signal. Herein, whereas the first flip-flop circuit 231 and the second flip-flop circuit 232 are provided in a first stage, the third flip-flop circuit 233 is provided in a second stage. As a result, in response to the transition of the multiphase clock signal Φ6 from the low level to the high level, the A signal output from the first flip-flop circuit 231 is input to the third flip-flop circuit 233 as the C signal via the multiplexer 234. That is, an output result of the first flip-flop circuit 231 is input to the third flip-flop circuit 233 while being affected by the signal delay due to the intermediation of the multiplexer 234. Thus, after the multiphase clock signal Φ6 has transitioned from the low level to the high level, the signal at the high level is input to the third flip-flop circuit 233 as the C signal. As a result, the third flip-flop circuit 233 outputs the signal at the low level as the timing signal based on the C signal at the low level which is input at a point in time when the multiphase clock signal Φ6 has transitioned from the low level to the high level.

During a period from the time instant t31 to the time instant t32, the multiphase clock signal Φ6 transitions from the high level to the low level, and at the time instant t32, the multiphase clock signal Φ2 transitions from the low level to the high level. The first flip-flop circuit 231 continuously outputs the signal at the high level as the A signal from the time instant t31. The second flip-flop circuit 232 continuously outputs the signal at the high level as the B signal from the time instant t30. Since the signal at the high level is continuously input from the gate circuit 214-2 from the time instant t30, the selection signal generation circuit 235 outputs the signal at the high level as the selection signal. Since the signal at the high level is input as the selection signal from the time instant t30, the multiplexer 234 outputs the A signal, that is, the signal at the high level as the C signal. Although the signal at the high level is input as the C signal, since it is before the input multiphase clock signal Φ6 transitions from the low level to the high level, the third flip-flop circuit 233 outputs the signal at the low level as the timing signal.

At the time instant t33, the multiphase clock signal Φ6 transitions from the low level to the high level.

The first flip-flop circuit 231 continuously outputs the signal at the high level as the A signal from the time instant t31. The second flip-flop circuit 232 continuously outputs the signal at the high level as the B signal from the time instant t30. Since the signal at the high level is continuously input from the gate circuit 214-2 from the time instant t30, the selection signal generation circuit 235 outputs the signal at the high level as the selection signal. Since the signal at the high level is input as the selection signal from the time instant t30, the multiplexer 234 outputs the A signal, that is, the signal at the high level as the C signal. Since the signal at the high level is input as the C signal, in response to the transition of the input multiphase clock signal Φ6 from the low level to the high level, the third flip-flop circuit 233 outputs the signal at the high level as the timing signal. Furthermore, for example, "8" is confirmed as the higher order bits based on the signal at the high level which has been output as the timing signal and on the Gray code G. It is noted that in the present specification, a value of the higher order bits is also expressed in decimal for convenience similarly as in the lower order bit, but in reality, a signal expressed in binary is held.

It is noted that at the time instant t30, the STOP signal transitions from the low level to the high level, and the multiphase clock signal Φ2 transitions from the low level to the high level, but the second flip-flop circuit 232 may output the signal at the low level as the B signal. This situation is based on a state in which the second flip-flop circuit 232 does not normally function as the flip-flop circuit due to a performance limitation in a case where timings at which two signals to be input transition from the low level to the high level are close to each other. In addition, at the time instant t30, after the multiphase clock signal Φ2 has transitioned from the low level to the high level, the STOP signal may transition from the low level to the high level, and the second flip-flop circuit 232 may output the signal at the low level as the B signal.

This situation is based on an operational delay of the circuit configured to generate the STOP signal or the circuit configured to transmit the STOP signal. However, according to the present embodiment, the higher order bits are generated without using the B signal the signal level of which may not be stable as described above, so that the highly accurate time to digital conversion can be performed. Therefore, according to the present embodiment, for example, even in a case where the signal quality of the multiphase clock signal Φ has degraded due to a degradation or the like of the duty ratio of the multiphase clock signal Φ, the highly accurate time to digital conversion can be performed.

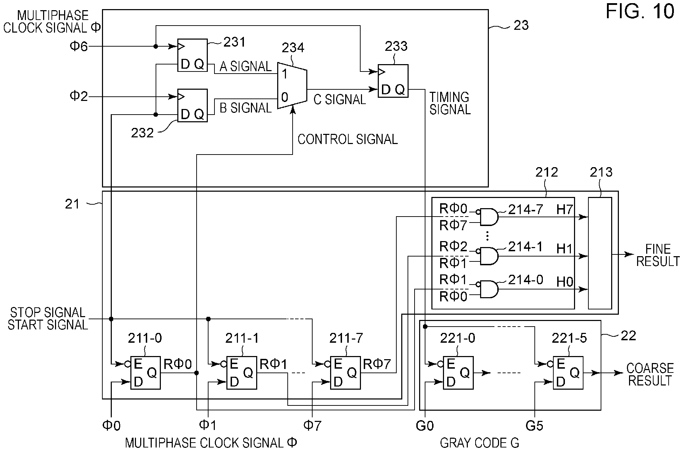

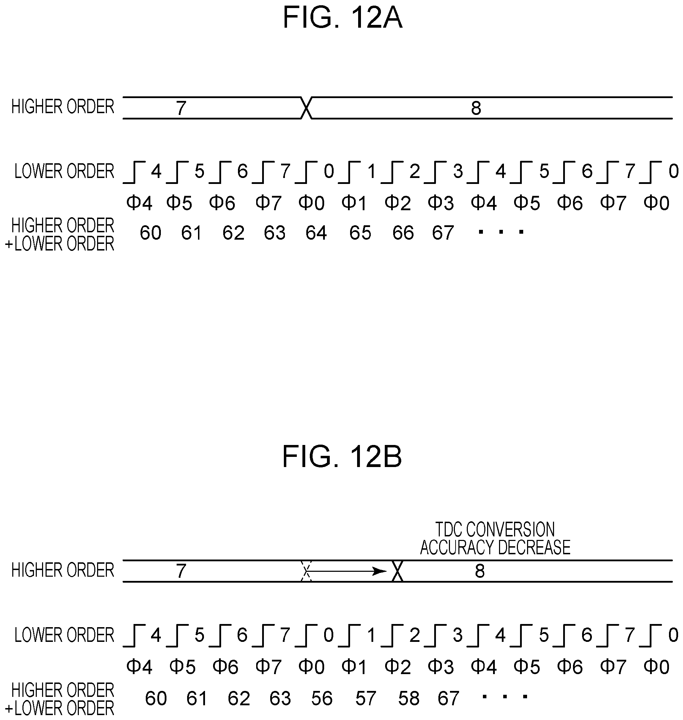

The TDC 20 according to a reference example will be described with reference to Fig. 10 to Figs. 12A and 12B. It is noted that the same reference sign is assigned to the components similar to that of the first embodiment, and the descriptions on these components may be omitted or simplified.

The reference example is different from the first embodiment in that the selection signal generation circuit 235 is not provided. In the reference example, a signal output from one latch circuit 211 among the plurality of latch circuits 211 included in the fine TDC 21 is input to the multiplexer 234 included in the synchronization circuit 23. Fig. 10 is an example of a circuit diagram of the TDC 20 according to the reference example.

The fine TDC 21 includes the plurality of latch circuits 211, the differentiation circuit 212, and the encoder 213. The plurality of latch circuits 211 are of D type. It is noted that the plurality of D-type latch circuits 211 may be a plurality of D-type flip-flop circuits. Note also that the fine TDC 21 may include a plurality of D-type latch circuits and a plurality of D-type flip-flop circuits. The START signal or the STOP signal is input to the inverting input nodes E (first input nodes) of the plurality of latch circuits 211, and the multiphase clock signal Φ is input to the input nodes D (second input nodes) of the plurality of latch circuits 211. In Fig. 10, as the multiphase clock signal Φ, for example, the multiphase clock signals Φ0 to Φ7 with different phases are respectively input to the plurality of corresponding latch circuits 211-0 to 211-7. That is, the multiphase clock signal Φ0 is input to the latch circuit 211-0, the multiphase clock signal Φ1 is input to the latch circuit 211-1, the multiphase clock signal Φ2 is input to the latch circuit 211-2, and the multiphase clock signal Φ3 is input to the latch circuit 211-3. The multiphase clock signal Φ4 is input to the latch circuit 211-4, the multiphase clock signal Φ5 is input to the latch circuit 211-5, the multiphase clock signal Φ6 is input to the latch circuit 211-6, and the multiphase clock signal Φ7 is input to the latch circuit 211-7. It is noted that the multiphase clock signals Φ1 to Φ7 have phases shifted in the stated order from the multiphase clock signal Φ0 to the multiphase clock signal Φ7, and a phase difference between clock signals with adjacent numbers is a predetermined amount "a". The output node of the latch circuit 211-0 is connected to the multiplexer 234 included in the synchronization circuit 23. The output nodes of the plurality of latch circuits 211 are connected to the differentiation circuit 212. The differentiation circuit 212 includes the plurality of gate circuits 214, and the output nodes of the plurality of latch circuits 211 are connected to the inverting input nodes or the non-inverting input nodes of the plurality of gate circuits 214. That is, the output node of the latch circuit 211-0 is connected to the non-inverting input node of the gate circuit 214-0, and the output node of the latch circuit 211-1 is connected to the inverting input node of the gate circuit 214-0. The output node of the latch circuit 211-1 is connected to the non-inverting input node of the gate circuit 214-1, and the output node of the latch circuit 211-2 is connected to the inverting input node of the gate circuit 214-1. The output node of the latch circuit 211-2 is connected to the non-inverting input node of the gate circuit 214-2, and the output node of the latch circuit 211-3 is connected to the inverting input node of the gate circuit 214-2. The output node of the latch circuit 211-3 is connected to the non-inverting input node of the gate circuit 214-3, and the output node of the latch circuit 211-4 is connected to the inverting input node of the gate circuit 214-3. The output node of the latch circuit 211-4 is connected to the non-inverting input node of the gate circuit 214-4, and the output node of the latch circuit 211-5 is connected to the inverting input node of the gate circuit 214-4. The output node of the latch circuit 211-5 is connected to the non-inverting input node of the gate circuit 214-5, and the output node of the latch circuit 211-6 is connected to the inverting input node of the gate circuit 214-5. The output node of the latch circuit 211-6 is connected to the non-inverting input node of the gate circuit 214-6, and the output node of the latch circuit 211-7 is connected to the inverting input node of the gate circuit 214-6. The output node of the latch circuit 211-7 is connected to the non-inverting input node of the gate circuit 214-7, and the output node of the latch circuit 211-0 is connected to the inverting input node of the gate circuit 214-7. The output nodes of the plurality of gate circuits 214 are connected to the encoder 213. The signal H0 output from the gate circuit 214-0, the signal H1 output from the gate circuit 214-1, the signal H2 output from the gate circuit 214-2, and the signal H3 output from the gate circuit 214-3 are input to the encoder 213. The signal H4 output from the gate circuit 214-4, the signal H5 output from the gate circuit 214-5, the signal H6 output from the gate circuit 214-6, and the signal H7 output from the gate circuit 214-7 are also input to the encoder 213. The encoder 213 encodes the signals output from the output nodes of the plurality of gate circuits 214 to output a binary code signal (fine result).

The coarse TDC 22 includes the plurality of latch circuits 221. The plurality of latch circuits 221 are of D type. It is noted that the plurality of D-type latch circuits 221 may be a plurality of D-type flip-flop circuits. Note also that the coarse TDC 22 may include a plurality of D-type latch circuits 221 and a plurality of D-type flip-flop circuits. The timing signal is input to the inverting input nodes E (first input nodes) of the plurality of latch circuits 221, and the Gray code G is input to the input nodes D (second input nodes) of the plurality of latch circuits 211. The signals output from the plurality of latch circuits 221 are output as the coarse result.

The synchronization circuit 23 includes the first flip-flop circuit 231, the second flip-flop circuit 232, the third flip-flop circuit 233, and the multiplexer 234. The first flip-flop circuit 231, the second flip-flop circuit 232, and the third flip-flop circuit 233 are of D type. It is noted that the first flip-flop circuit 231, the second flip-flop circuit 232, and the third flip-flop circuit 233 may be a D-type latch circuit. Note also that the synchronization circuit 23 may include a plurality of flip-flop circuits and a plurality of latch circuits. The START signal or the STOP signal is input to the input nodes D (first input nodes) of the first flip-flop circuit 231 and the second flip-flop circuit 232. The multiphase clock signal Φ is input to the clock nodes (second input nodes) of the first flip-flop circuit 231 and the second flip-flop circuit 232. In Fig. 10, as the multiphase clock signal Φ, for example, among the multiphase clock signals Φ1 to Φ7 with different phases, the multiphase clock signal Φ6 is input to the first flip-flop circuit 231, and the multiphase clock signal Φ2 is input to the second flip-flop circuit 232. It is noted that the phase difference between the phase of the multiphase clock signal Φ2 and the phase of the multiphase clock signal Φ6 is set as a half of a period. The output node of the first flip-flop circuit 231 is connected to the input node 1 of the multiplexer 234, and the output node of the second flip-flop circuit 232 is connected to the input node 0 of the multiplexer 234. The signal output by the first flip-flop circuit 231 is set as the A signal. The signal output by the second flip-flop circuit 232 is set as the B signal. The control signal output from the latch circuit 211-0 is input to the multiplexer 234. The output node of the multiplexer 234 is connected to the input node D of the third flip-flop circuit 233. The signal output by the multiplexer 234 is set as the C signal. The multiplexer 234 outputs the C signal generated by using the A signal or the B signal to the third flip-flop circuit 233 based on the control signal. That is, the multiplexer 234 selects one signal out of the A signal or the B signal and outputs the selected signal as the C signal. The C signal output from the multiplexer 234 is input to the input node D of the third flip-flop circuit 233, and the multiphase clock signal Φ is input to the clock node of the third flip-flop circuit 233. In Fig. 10, as the multiphase clock signal Φ, for example, the multiphase clock signal Φ6 that has been input to the first flip-flop circuit 231 is also input to the third flip-flop circuit 233. The output node of the third flip-flop circuit 233 is connected to the inverting input nodes E of the plurality of latch circuits 221 included in the coarse TDC 22. The timing signal output from the third flip-flop circuit 233 is input to the plurality of latch circuits 221.

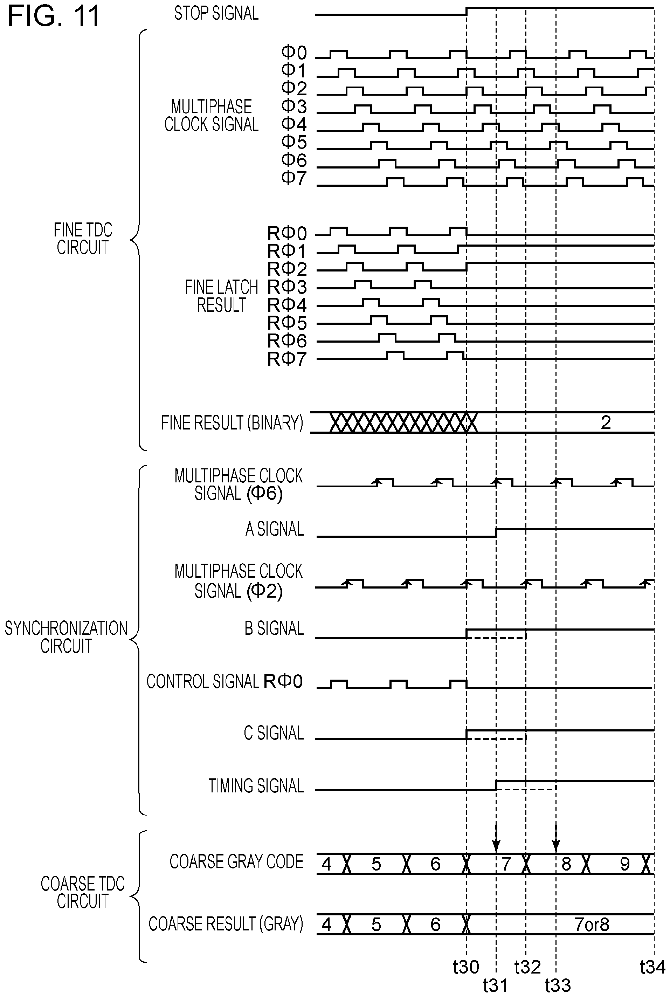

Fig. 11 is an example of the drive timing chart diagram of the TDC 20 corresponding to the Stop channel according to the reference example. Similarly as in Fig. 9, Fig. 11 illustrates a case where the signal quality of the multiphase clock signal Φ has degraded due to a degradation or the like of the duty ratio of the multiphase clock signal Φ in Fig. 7, for example.

In Fig. 11, at the time instant t30, the STOP signal transitions from the low level to the high level, and at the time instant t34 and the subsequent time, the STOP signal transitions from the high level to the low level.

The STOP signal is input to the inverting input nodes E of the plurality of latch circuits 211, and the multiphase clock signal Φ is input to the input nodes D of the plurality of latch circuits 211. As a result, during at least the period from the time instant t30 to the time instant t34, the plurality of latch circuits 211 output the level (for example, the low level or the high level) of the multiphase clock signal Φ that has been input to the input node D at the time instant t30.

The plurality of gate circuits 214 output the signal at the high level in a case where the signal input to the inverting input node is the low level and the signal input to the non-inverting input node is the high level. On the other hand, the plurality of gate circuits 214 output the signal at the low level in a case where the signal input to the inverting input node is the high level or a case where the signal input to the non-inverting input node is the low level.

The STOP signal is input to the input nodes D of the first flip-flop circuit 231 and the second flip-flop circuit 232. The multiphase clock signal Φ6 is input to the clock node of the first flip-flop circuit 231. The multiphase clock signal Φ2 is input to the clock node of the second flip-flop circuit 232. As a result, during the period from the time instant t30 to the time instant t34, before the multiphase clock signal Φ6 transitions from the low level to the high level, the first flip-flop circuit 231 outputs the signal at the low level as the A signal. During the period from the time instant t30 to the time instant t34, after the multiphase clock signal Φ6 has transitioned from the low level to the high level, the first flip-flop circuit 231 outputs the signal at the high level as the A signal. During the period from the time instant t30 to the time instant t34, before the multiphase clock signal Φ2 transitions from the low level to the high level, the second flip-flop circuit 232 outputs the signal at the low level as the B signal. During the period from the time instant t30 to the time instant t34, after the multiphase clock signal Φ2 has transitioned from the low level to the high level, the second flip-flop circuit 232 outputs the signal at the high level as the B signal.

The A signal is input to the input node 1 of the multiplexer 234, and the B signal is input to the input node 0 of the multiplexer 234. The multiplexer 234 outputs either the A signal or the B signal as the C signal based on the control signal input from the latch circuit 211-0. For example, the multiplexer 234 outputs the A signal as the C signal in a case where the control signal is the high level and outputs the B signal as the C signal in a case where the control signal is the low level.

The C signal is input to the input node D of the third flip-flop circuit 233, and the multiphase clock signal Φ6 is input to the clock node of the third flip-flop circuit 233. As a result, during the period from the time instant t30 to the time instant t34, the third flip-flop circuit 233 outputs the C signal at a point in time when the multiphase clock signal Φ6 transitions from the low level to the high level as the timing signal.

The timing signal is input to the inverting input nodes E of the plurality of latch circuits 221, and the Gray code G is input to the input nodes D of the plurality of latch circuits 221. As a result, during the period from the time instant t30 to the time instant t34, the plurality of latch circuits 221 output the level of the Gray code G input to the input node D after the timing signal input to the inverting input node E has transitioned to the high level.

In accordance with the above-described drive, the fine TDC 21 outputs a fine result corresponding to the lower order bits based on the signals output from the plurality of gate circuits 214. The coarse TDC 22 outputs a coarse result corresponding to the higher order bits based on the signals output from the plurality of latch circuits 221.

In Fig. 11, at the time instant t30, the multiphase clock signal Φ1 is the high level, the multiphase clock signals Φ3 to Φ7 are the low level, the multiphase clock signal Φ0 transitions from the high level to the low level, and the multiphase clock signal Φ2 transitions from the low level to the high level. As a result, in response to the transition of the STOP signal from the low level to the high level, the latch circuits 211-1 and 211-2 output the signal at the high level, and the latch circuits 211-0 and 211-3 to 211-7 output the signal at the low level. Then, based on the signals output from the plurality of latch circuits 211, the gate circuit 214-2 outputs the signal at the high level, and the gate circuits 214-0, 214-1, and 214-3 to 214-7 output the signal at the low level. The encoder 213 confirms "2", for example, as the lower order bits based on the signal at the high level output from the gate circuit 214-2. It is noted that in the present specification, a value of the lower order bits is expressed in decimal for convenience, but in reality, a signal expressed in binary is held.

At the time instant t30, since it is before the input multiphase clock signal Φ6 transitions from the low level to the high level, the first flip-flop circuit 231 outputs the signal at the low level as the A signal. In addition, at the time instant t30, since the input multiphase clock signal Φ2 transitions from the low level to the high level, the second flip-flop circuit 232 outputs the signal at the high level as the B signal. Since the signal at the low level is input from the latch circuit 211-0 as the control signal, the multiplexer 234 outputs the B signal, that is, the signal at the high level as the C signal. Although the signal at the high level is input as the C signal, since it is before the input multiphase clock signal Φ6 transitions from the low level to the high level, the third flip-flop circuit 233 outputs the signal at the low level as the timing signal.

During the period from the time instant t30 to the time instant t31, the multiphase clock signal Φ2 transitions from the high level to the low level, and at the time instant t31, the multiphase clock signal Φ6 transitions from the low level to the high level. Since the input multiphase clock signal Φ6 transitions from the low level to the high level, the first flip-flop circuit 231 outputs the signal at the high level as the A signal. The second flip-flop circuit 232 continuously outputs the signal at the high level as the B signal from the time instant t30. Since the signal at the low level is continuously input as the control signal from the time instant t30, the multiplexer 234 outputs the B signal, that is, the signal at the high level as the C signal. Since the signal at the high level is input as the C signal, in response to the transition of the input multiphase clock signal Φ6 from the low level to the high level, the third flip-flop circuit 233 outputs the signal at the high level as the timing signal. Furthermore, for example, "7" is confirmed as the higher order bits based on the signal at the high level which has been output as the timing signal and on the Gray code G. It is noted that in the present specification, a value of the higher order bits is also expressed in decimal for convenience similarly as in the lower order bit, but in reality, a signal expressed in binary is held.

It is noted that at the time instant t30, the STOP signal transitions from the low level to the high level, and the multiphase clock signal Φ2 transitions from the low level to the high level, but the second flip-flop circuit 232 may output the signal at the low level as the B signal. This situation is based on a state in which the second flip-flop circuit 232 does not normally function as the flip-flop circuit due to a performance limitation in a case where timings at which two signals to be input transition from the low level to the high level are close to each other. In addition, at the time instant t30, after the multiphase clock signal Φ2 has transitioned from the low level to the high level, the STOP signal may transition from the low level to the high level, and the second flip-flop circuit 232 may output the signal at the low level as the B signal.

This situation is based on an operational delay of the circuit configured to generate the STOP signal or the circuit configured to transmit the STOP signal.

In the above-described case, the B signal is at the low level during a period from the time instant t30 to the time instant t32. In addition, since the signal at the low level is input as the C signal, the third flip-flop circuit 233 outputs the signal at the low level as the timing signal. Then, at the time instant t32, the multiphase clock signal Φ2 transitions from the low level to the high level. The first flip-flop circuit 231 continuously outputs the signal at the high level as the A signal from the time instant t31. Since the input multiphase clock signal Φ2 transitions from the low level to the high level, the second flip-flop circuit 232 outputs the signal at the high level as the B signal. Since the signal at the low level is continuously input as the control signal from the time instant t30, the multiplexer 234 outputs the B signal, that is, the signal at the high level as the C signal. Although the signal at the high level is input as the C signal, since it is before the input multiphase clock signal Φ6 transitions from the low level to the high level, the third flip-flop circuit 233 outputs the signal at the low level as the timing signal. At the time instant t33, the multiphase clock signal Φ6 transitions from the low level to the high level. The first flip-flop circuit 231 continuously outputs the signal at the high level as the A signal from the time instant t31. The second flip-flop circuit 232 continuously outputs the signal at the high level as the B signal from the time instant t32. Since the signal at the low level is continuously input as the control signal from the time instant t30, the multiplexer 234 outputs the B signal, that is, the signal at the high level as the C signal. Since the signal at the high level is input as the C signal, in response to the transition of the input multiphase clock signal Φ6 from the low level to the high level, the third flip-flop circuit 233 outputs the signal at the high level as the timing signal. Furthermore, for example, "8" is confirmed as the higher order bits based on the signal at the high level which has been output as the timing signal and on the Gray code G. It is noted that in the present specification, a value of the higher order bits is also expressed in decimal for convenience similarly as in the lower order bit, but in reality, a signal expressed in binary is held.

Therefore, for example, in a case where the signal quality of the multiphase clock signal Φ has degraded due to a degradation or the like of the duty ratio of the multiphase clock signal Φ, the value to be confirmed as the higher order bits may vary. In the above-mentioned case, a code error of a connection between coarse TDC data and fine TDC data occurs, and the time to digital conversion accuracy decreases.

Figs. 12A and 12B are examples of diagrams for describing signal processing of the TDC 20 according to the first embodiment and the reference example. Fig. 12A illustrates a case where a code error of the connection between the coarse TDC data and the fine TDC data does not occur as in the first embodiment. Fig. 12B illustrates a case where a code error of the connection between the coarse TDC data and the fine TDC data occurs as in the reference example.

It is noted that the coarse TDC data and the fine TDC data are connected by converting the Gray code corresponding to the coarse TDC data into a binary code. This processing may be executed in the digital processing circuit 90 or may be executed outside the distance image sensor 100.

According to the first embodiment described with reference to Fig. 7 to Fig. 9, "8" is selectively generated as the higher order bits for the STOP signal transitioning from the low level to the high level at a predetermined timing. As a result, as illustrated in Fig. 12A, an inconsistency does not occur when the coarse TDC data and the fine TDC data are connected. On the other hand, in the reference example described with reference to Fig. 11, different higher order bits may be generated for the STOP signal transitioning from the low level to the high level at a predetermined timing. Herein, a case of the following setting will be considered where "8" is to be correctly generated as the higher order bits for the predetermined STOP signal illustrated in Fig. 11 by taking into account the operational delay in the circuit or the performance limitation of the second flip-flop circuit 232. As illustrated in Fig. 12B, "8" is to be originally generated as the higher order bits for the predetermined STOP signal illustrated in Fig. 11, but "7" may be generated as the higher order bits. In this case, when the coarse TDC data and the fine TDC data are connected, "64, 65, 66" are to be originally generated, but "56, 57, 58" are generated. Thus, an inconsistency occurs when the coarse TDC data and the fine TDC data are connected.

In the reference example, since the fine TDC 21 generates the timing signal by using both rising and falling timings of the multiphase clock signal Φ, the accuracy of the time to digital conversion decreases as described above. On the other hand, according to the first embodiment, the fine TDC 21 generates the timing signal by using either the rising timing or the falling timing of the multiphase clock signal Φ, so that the highly accurate time to digital conversion can be performed.

### Second Embodiment

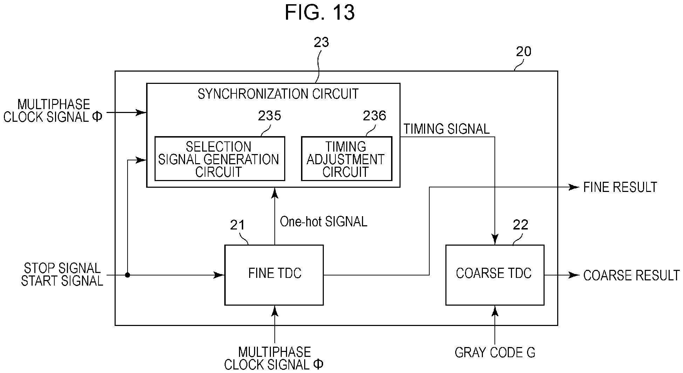

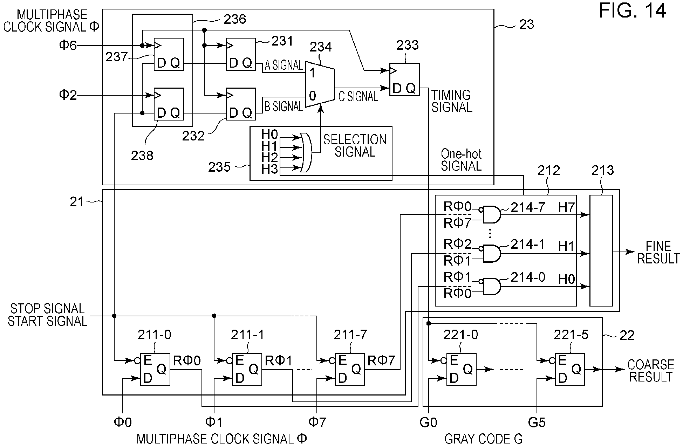

The time to digital converter according to the second embodiment based on the present invention will be described with reference to Fig. 13 and Fig. 14. It is noted that the same reference sign is assigned to the components similar to that of the first embodiment, and the descriptions on these components may be omitted or simplified.

The present embodiment is different from the first embodiment in that the synchronization circuit 23 includes a timing adjustment circuit 236. Fig. 13 is an example of a block diagram of the TDC 20 according to the present embodiment. In Fig. 13, the synchronization circuit 23 further includes the timing adjustment circuit 236. The timing adjustment circuit 236 is a circuit configured to compensate for a delay of signal processing due to an operational delay in at least one of the fine TDC 21 and the synchronization circuit 23 to output a timing signal.

Fig. 14 is an example of a circuit diagram of the TDC 20 according to the present embodiment.

The timing adjustment circuit 236 includes a fourth flip-flop circuit 237 and a fifth flip-flop circuit 238. The fourth flip-flop circuit 237 and the fifth flip-flop circuit 238 are of D type. It is noted that the fourth flip-flop circuit 237 and the fifth flip-flop circuit 238 may be a D-type latch circuit. The START signal or the STOP signal is input to input nodes D (first input nodes) of the fourth flip-flop circuit 237 and the fifth flip-flop circuit 238. The multiphase clock signal Φ is input to clock nodes (seconds input nodes) of the fourth flip-flop circuit 237 and the fifth flip-flop circuit 238. In Fig. 14, as the multiphase clock signal Φ, for example, among the multiphase clock signals Φ 1 to Φ7 with different phases, the multiphase clock signal Φ6 is input to the fourth flip-flop circuit 237, and the multiphase clock signal Φ2 is input to the fifth flip-flop circuit 238. It is noted that the phase difference between the phase of the multiphase clock signal Φ2 and the phase of the multiphase clock signal Φ6 is set as a half of a period. An output node of the fourth flip-flop circuit 237 is connected to the input node D of the first flip-flop circuit 231, and an output node of the fifth flip-flop circuit 238 is connected to the input node D of the second flip-flop circuit 232.

Thus, according to the present embodiment, even in a case where the timing at which the STOP signal transitions from the low level to the high level is close to the timing at which the multiphase clock signal Φ transitions from the low level to the high level or a case where the operational delay in the circuit occurs, it is possible to realize the highly accurate time to digital conversion.

Furthermore, according to the present embodiment, even in a case where the operational delay has occurred in the fine TDC 21, the synchronization circuit 23, or the like, the highly accurate time to digital conversion can be performed.

### Third Embodiment

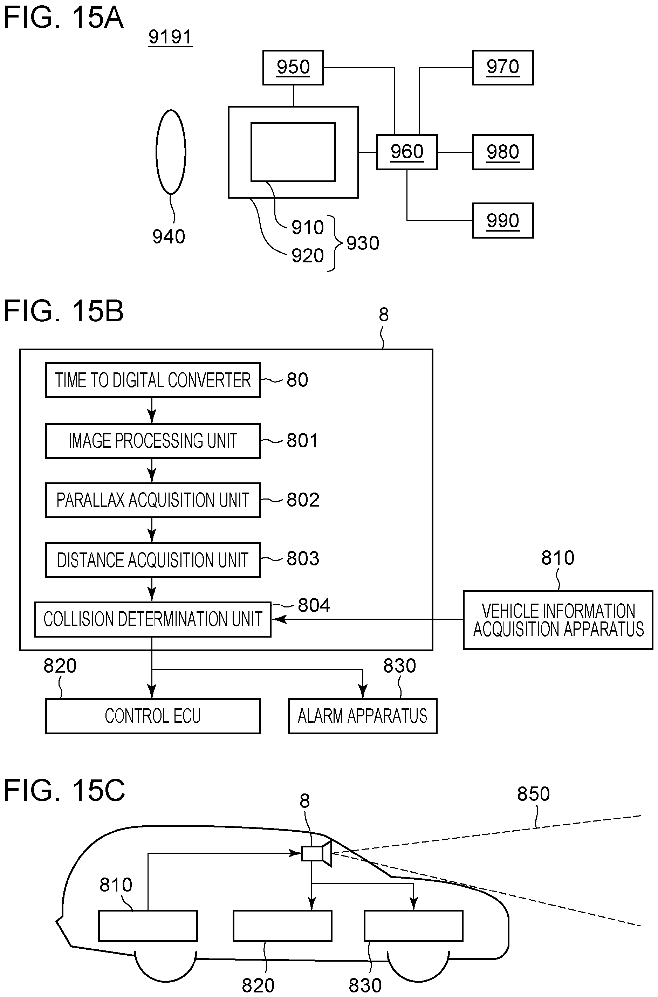

A third embodiment can be applied to any of the first embodiment and the second embodiment. Figs. 15A, 15B, and 15C are schematic diagrams for describing an equipment 9191 including a semiconductor apparatus 930 of the present embodiment. The time to digital converter of each of the above-mentioned embodiments can be used as the semiconductor apparatus 930. The equipment 9191 including the semiconductor apparatus 930 will be described in detail. The semiconductor apparatus 930 can include a semiconductor device 910. In addition to the semiconductor device 910, the semiconductor apparatus 930 can include a package 920 that accommodates the semiconductor device 910. The package 920 can include a base to which the semiconductor device 910 is fixed and a lid such as glass facing the semiconductor device 910. The package 920 can further include a bonding member such as a bonding wire or a bump that connects a terminal provided in the base and a terminal provided in the semiconductor device 910.

The equipment 9191 may include at least any of an optical apparatus 940, a control apparatus 950, a processing apparatus 960, a display apparatus 970, a storage device 980, and a mechanical apparatus 990. The optical apparatus 940 corresponds to the semiconductor apparatus 930. The optical apparatus 940 is, for example, a lens, a shutter, or a mirror and includes an optical system configured to guide light to the semiconductor apparatus 930. The control apparatus 950 controls the semiconductor apparatus 930. The control apparatus 950 is, for example, a semiconductor apparatus such as an application specific integrated circuit (ASIC).

The processing apparatus 960 processes a signal output from the semiconductor apparatus 930. The processing apparatus 960 is a semiconductor apparatus such as a central processing unit (CPU) or an ASIC that constitutes an analog front end (AFE) or a digital front end (DFE). The display apparatus 970 is an electroluminescence (EL) display apparatus or a liquid crystal apparatus configured to display information (image) acquired by the semiconductor apparatus 930. The storage device 980 is a magnetic device or a semiconductor device configured to store the information (image) acquired by the semiconductor apparatus 930. The storage device 980 is a volatile memory such as a static random access memory (SRAM) or a dynamic random access memory (DRAM) or a non-volatile memory such as a flash memory or a hard disk drive.

The mechanical apparatus 990 includes a movable part or a propulsive part such as a motor and an engine. In the equipment 9191, the signal output from the semiconductor apparatus 930 is displayed on the display apparatus 970 or transmitted to the outside by a communication apparatus (not illustrated) included in the equipment 9191. For this reason, the equipment 9191 may preferably separately include the storage device 980 or the processing apparatus 960 in addition to a storage circuit or an arithmetic operation circuit included in the semiconductor apparatus 930. The mechanical apparatus 990 may be controlled based on the signal output from the semiconductor apparatus 930.

The equipment 9191 is also preferably used as electronic equipment such as an information terminal (for example, a smartphone or a wearable terminal) having a shooting function or a camera (for example, an interchangeable lens camera, a compact camera, a video camera, or a surveillance camera). The mechanical apparatus 990 in the camera can drive parts of the optical apparatus 940 for zooming, focusing, and a shutter operation. Alternatively, the mechanical apparatus 990 in the camera can move the semiconductor apparatus 930 for an image stabilization operation.

The equipment 9191 may be transportation equipment such as a vehicle, a ship, or a flying object (such as a drone or aircraft). The mechanical apparatus 990 in the transportation equipment may be used as a transportation apparatus. The equipment 9191 serving as the transportation equipment may be preferably used as a component configured to transport the semiconductor apparatus 930 or a component configured to assist and/or automate driving (piloting) by the shooting function. The processing apparatus 960 configured to assist and/or automate driving (piloting) can perform processing to operate the mechanical apparatus 990 serving as the transportation apparatus based on the information acquired by the semiconductor apparatus 930. Alternatively, the equipment 9191 may be medical equipment such as an endoscope, measuring equipment such as a distance measuring sensor, analytical equipment such as an electron microscope, office equipment such as a copier, or industrial equipment such as a robot.

According to the above-described embodiment, it becomes possible to attain a satisfactory pixel characteristic. Therefore, a value of the semiconductor apparatus can be increased. For the increase in the value mentioned herein, at least any of an addition of a function, an improvement of a performance, an improvement of a characteristic, an improvement of a reliability, an improvement of a manufacturing yield, a reduction of an environmental impact, a cost reduction, a size reduction, and a weight reduction applies.

Therefore, when the semiconductor apparatus 930 according to the present embodiment is used as the equipment 9191, the value of the equipment can also be improved. For example, by mounting the semiconductor apparatus 930 to the transportation equipment, it is possible to attain an excellent performance when an outside of the transportation equipment is shot or an external environment is measured. Thus, when the transportation equipment is to be manufactured and to be on sale, a decision of mounting the semiconductor apparatus according to the present embodiment to the transportation equipment is advantageous in an improvement of the performance of the transportation equipment itself. In particular, the semiconductor apparatus 930 is preferably used as the transportation equipment configured to perform driving assistance and/or automated driving of the transportation equipment by using the information acquired by the above-described semiconductor apparatus.

A time to digital conversion system and a moving object of the present embodiment will be described with reference to Figs. 15B and 15C.

Fig. 15B illustrates an example of a time to digital conversion system related to an on-vehicle camera. A time to digital conversion system 8 includes a time to digital converter 80. The time to digital converter 80 is the time to digital converter described in any of the above-mentioned embodiments. The time to digital conversion system 8 has an image processing unit 801 configured to perform image processing on a plurality of pieces of image data acquired by the time to digital converter 80. The time to digital conversion system 8 also includes a parallax acquisition unit 802 configured to calculate a parallax (phase difference of parallax images) from a plurality of pieces of image data acquired by the time to digital conversion system 8. Herein, the time to digital conversion system 8 may include, for example, an optical system which is not illustrated in the drawing such as a lens, a shutter, or a mirror configured to guide light to the time to digital converter 80. A plurality of photoelectric conversion units that are substantially conjugate with a pupil of the optical system may be arranged for pixels included in the time to digital converter 80. For example, the plurality of photoelectric conversion units that are substantially conjugate with the pupil are arranged so as to correspond to a single microlens. When the plurality of photoelectric conversion units receive light beams that have passed through mutually different positions of the pupil of the optical system, the time to digital converter 80 outputs image data corresponding to the light beams that have passed through different positions. Then, the parallax acquisition unit 802 may calculate the parallax by using the output image data. The time to digital conversion system 8 also includes a distance acquisition unit 803 configured to calculate a distance to the target object based on the calculated parallax and a collision determination unit 804 configured to determine whether or not there is a possibility of collision based on the calculated distance. Herein, the parallax acquisition unit 802 and the distance acquisition unit 803 are examples of a distance information acquisition unit configured to acquire distance information of a distance to the target object. That is, the distance information refers to information related to a parallax, a defocus amount, a distance to the target object, or the like. The collision determination unit 804 may determine the possibility of collision by using any of these pieces of distance information. It is noted that the distance information may be acquired based on a time of flight (ToF). The distance information acquisition unit may be realized by specifically designed hardware or may be realized by a software module. In addition, the distance information acquisition unit may be realized by a field programmable gate array (FPGA), an application specific integrated circuit (ASIC), or the like or may be realized by a combination of these components.

The time to digital conversion system 8 is connected to a vehicle information acquisition apparatus 810 and can acquire vehicle information such as a vehicle speed, a yaw rate, or a steering angle. The time to digital conversion system 8 is also connected to a control electronic control unit (ECU) 820 serving as a control apparatus configured to output a control signal for generating a braking force for the vehicle based on a result of the determination in the collision determination unit 804. The time to digital conversion system 8 is also connected to an alarm apparatus 830 configured to issue an alarm to a driver based on a result of the determination in the collision determination unit 804. For example, in a case where the possibility of collision is high as the determination result of the collision determination unit 804, the ECU 820 performs vehicle control to avoid a collision or mitigate damage by applying a brake, releasing an accelerator, reducing an engine output, or the like. The alarm apparatus 830 warns a user by sounding an alarm such as a sound, displaying alarm information on a screen such as a car navigation system, applying vibration to a seat belt or a steering wheel, or the like.

According to the present embodiment, an image of a surrounding of the vehicle, for example, a front area or a rear area is to be sensed by the time to digital conversion system 8. Fig. 15C illustrates the time to digital conversion system 8 in a case where an image of the front area of the vehicle (image sensing area 850) is to be sensed. The vehicle information acquisition apparatus 810 transmits an instruction to the time to digital conversion system 8 or the time to digital converter 80. With such a configuration, an accuracy of the distance measurement can be further improved.

In the above, the example of the control to avoid the collision with other vehicles has been described, but the embodiment can be applied to control for autonomous drive by following other vehicles, control for autonomous drive so as not to stray from its lane, or the like. Furthermore, the time to digital conversion system 8 can be applied to not only a vehicle such as a car but also a moving object (mobile apparatus) such as, for example, a ship, aircraft, or an industrial robot. This moving object includes either or both of a drive force generation unit configured to generate a drive force to be mainly used for movement of the moving object and a rotating body to be mainly used for movement of the moving object. The drive force generation unit may be an engine, a motor, or the like. The rotating body may be a tire, a wheel, a screw of the ship, a propeller of the aircraft, or the like. Moreover, the embodiment can be applied to not only the moving object but also an equipment that widely uses object recognition such as intelligent transport systems (ITS).

In the present specification, expressions "A or B", "at least one of A and B", "at least one of A or/and B", and "one or more of A or/and B" contain all possible combinations of enumerated items unless otherwise explicitly defined. That is, the above expressions are to be understood to disclose all of the following cases including a case where at least one A is included, a case where at least one B is included, and a case where at least one A and at least one B are both included. The same also applies to a combination of three or more elements.

The embodiments described above can be modified as appropriate in a scope without departing from the technical concept. It is noted that the content disclosed in the present specification is not limited to described configurations in the present specification but also includes all matters that can be understood from the present specification and the accompanying drawings of the present specification. The content disclosed in the present specification also includes a complement set of concepts described in the present specification. That is, when a phrase "A is larger than B" is stated in the present specification, for example, even when a phrase "A is not larger than B" is omitted, it can be construed that the present specification discloses a notion that "A is not larger than B". This is because in a case where the phrase "A is larger than B" is stated, it is assumed that a case where "A is not larger than B" is taken into consideration.

It is noted that the disclosure of the present embodiment includes the following configurations.

Configuration 1. A time to digital converter that outputs time interval digital data having multiple bits according to a time interval from a first timing to a second timing, the time to digital converter including a first circuit configured to generate lower order bits among the multiple bits, a second circuit configured to generate higher order bits among the multiple bits, and a third circuit configured to synchronize the first circuit and the second circuit by generating a second signal with use of a first signal output from the first circuit and outputting the second signal to the second circuit, in which the first signal is generated by using a signal with multiple bits among the lower order bits.

Configuration 2. The time to digital converter according to Configuration 1, in which each of the first circuit, the second circuit, and the third circuit includes a plurality of flip-flop circuits, a plurality of latch circuits, or a flip-flop circuit and a latch circuit.

Configuration 3. The time to digital converter according to Configuration 1 or 2, in which each of the plurality of flip-flop circuits, each of the plurality of latch circuits, or each of the flip-flop circuit and the latch circuit which are included in the first circuit has a first input node and a second input node, a signal corresponding to the second timing is input to the first input node, and a clock signal with a different phase is input to the second input node.

Configuration 4. The time to digital converter according to any one of Configurations 1 to 3, in which the first circuit includes a differentiation circuit configured to generate the first signal by performing differentiation processing on a signal output from each of the plurality of flip-flop circuits, each of the plurality of latch circuits, or each of the flip-flop circuit and the latch circuit which are included in the first circuit.

Configuration 5. The time to digital converter according to any one of Configurations 1 to 4, in which the differentiation circuit has a plurality of input nodes and a plurality of output nodes, the plurality of input nodes are connected to an output node included in each of the plurality of flip-flop circuits, each of the plurality of latch circuits, or each of the flip-flop circuit and the latch circuit, and the plurality of output nodes are connected to the third circuit.

Configuration 6. The time to digital converter according to any one of Configurations 1 to 5, in which each of the plurality of flip-flop circuits, each of the plurality of latch circuits, or each of the flip-flop circuit and the latch circuit which are included in the second circuit has a first input node and a second input node, the second signal is input to the first input node, and a Gray code with a different value is input to the second input node.

Configuration 7. The time to digital converter according to any one of Configurations 1 to 6, in which each of the plurality of flip-flop circuits, each of the plurality of latch circuits, or each of the flip-flop circuit and the latch circuit which are included in the third circuit has a first input node and a second input node, a signal corresponding to the second timing is input to the first input node, and a clock signal with a different phase is input to the second input node.

Configuration 8. The time to digital converter according to any one of Configurations 1 to 7, in which the third circuit includes a selection circuit configured to receive, as inputs, a plurality of signals output from the plurality of flip-flop circuits, the plurality of latch circuits, or the flip-flop circuit and the latch circuit and a selection signal, select one signal from among the plurality of signals by using the selection signal, and output the one signal.

Configuration 9. The time to digital converter according to any one of Configurations 1 to 8, in which the third circuit includes a generation circuit configured to generate the selection signal.

Configuration 10. The time to digital converter according to any one of Configurations 1 to 9, in which the generation circuit includes an output node and a plurality of input nodes, the plurality of input nodes are connected to the first circuit, and the output node is connected to the selection circuit.

Configuration 11. The time to digital converter according to any one of Configurations 1 to 10, in which the first circuit includes a differentiation circuit configured to generate the first signal by performing differentiation processing on a signal output from each of the plurality of flip-flop circuits, each of the plurality of latch circuits, or each of the flip-flop circuit and the latch circuit which are included in the first circuit, and the plurality of output nodes included in the differentiation circuit are connected to the plurality of input nodes included in the generation circuit.

Configuration 12. The time to digital converter according to any one of Configurations 1 to 11, in which the third circuit includes a timing adjustment circuit configured to compensate for a delay of signal processing which has occurred in at least one of the first circuit and the third circuit.

Configuration 13. A distance measuring apparatus including a light receiving unit configured to receive pulsed light which has been emitted towards a target object and reflected in the target object, and the time to digital converter according to any one of Configurations 1 to 12, in which in a case where a timing at which the pulsed light has been emitted is set as the first timing and a timing at which the pulsed light has been received is set as the second timing, the time to digital converter acquires distance information of a distance to the target object based on the time interval digital data corresponding to the time interval from the first timing to the second timing.

Configuration 14. The distance measuring apparatus according to Configuration 13, further including a light emitting unit configured to emit the pulsed light.

Configuration 15. The distance measuring apparatus according to Configuration 14, in which the light receiving unit includes a plurality of light receiving units, the plurality of light receiving units being arranged across a plurality of rows and a plurality of columns, and the first circuit, the second circuit, and the third circuit are provided for each row among the plurality of rows.

Configuration 16. The distance measuring apparatus according to Configuration 14, in which the light receiving unit includes a plurality of light receiving units, the plurality of light receiving units being arranged across a plurality of rows and a plurality of columns, and the first circuit, the second circuit, and the third circuit are provided for each of the light receiving units.

Configuration 17. The distance measuring apparatus according to Configuration 14, in which the light receiving unit includes a plurality of light receiving units, the plurality of light receiving units being arranged across a plurality of rows and a plurality of columns, and the first circuit, the second circuit, and the third circuit are provided for each subarray including the plurality of light receiving units.

Configuration 18. A moving object including the distance measuring apparatus according to Configuration 14, and a control unit configured to control the moving object based on the distance information acquired by the distance measuring apparatus.

Configuration 19. An equipment including the time to digital converter according to any one of Configurations 1 to 12, in which the equipment further includes at least any of an optical apparatus configured to guide light to the time to digital converter, a control apparatus configured to control the time to digital converter, a processing apparatus configured to process a signal output from the time to digital converter, a display apparatus configured to display information acquired in the time to digital converter, a storage device configured to store information acquired in the time to digital converter, and a mechanical apparatus arranged to operate based on information acquired in the time to digital converter.

While the present invention has been described with reference to embodiments, it is to be understood that the invention is not limited to the disclosed embodiments. The scope of the following claims is to be accorded the broadest interpretation so as to encompass all such modifications and equivalent structures and functions.

## Claims

1. A time to digital converter that outputs time interval digital data having multiple bits according to a time interval from a first timing to a second timing, the time to digital converter comprising:
a first circuit (21) configured to generate lower order bits among the multiple bits;
a second circuit (22) configured to generate higher order bits among the multiple bits; and
a third circuit (23) configured to synchronize the first circuit and the second circuit by generating a second signal with use of a first signal output from the first circuit and outputting the second signal to the second circuit, wherein
the first signal is generated by using a signal with multiple bits among the lower order bits.

2. The time to digital converter according to Claim 1, wherein
each of the first circuit (21), the second circuit (22), and the third circuit (23) includes a plurality of flip-flop circuits, a plurality of latch circuits, or a flip-flop circuit and a latch circuit (211, 221, 231, 232, 233).

3. The time to digital converter according to Claim 1 or 2, wherein
each of the plurality of flip-flop circuits, each of the plurality of latch circuits, or each of the flip-flop circuit and the latch circuit which are included in the first circuit (21) has a first input node (E) and a second input node (D), a signal corresponding to the second timing is input to the first input node (E), and a clock signal with a different phase is input to the second input node (D).

4. The time to digital converter according to any one of Claims 1 to 3, wherein
the first circuit (21) includes a differentiation circuit (212) configured to generate the first signal by performing differentiation processing on a signal output from each of the plurality of flip-flop circuits, each of the plurality of latch circuits, or each of the flip-flop circuit and the latch circuit which are included in the first circuit (21).

5. The time to digital converter according to Claim 4, wherein
the differentiation circuit (212) has a plurality of input nodes and a plurality of output nodes, the plurality of input nodes are connected to an output node included in each of the plurality of flip-flop circuits, each of the plurality of latch circuits, or each of the flip-flop circuit and the latch circuit, and the plurality of output nodes are connected to the third circuit (23).

6. The time to digital converter according to any one of Claims 1 to 5, wherein
each of the plurality of flip-flop circuits, each of the plurality of latch circuits, or each of the flip-flop circuit and the latch circuit which are included in the second circuit (22) has a first input node and a second input node, the second signal is input to the first input node, and a Gray code with a different value is input to the second input node.

7. The time to digital converter according to any one of Claims 1 to 6, wherein
each of the plurality of flip-flop circuits, each of the plurality of latch circuits, or each of the flip-flop circuit and the latch circuit which are included in the third circuit (23) has a first input node and a second input node, a signal corresponding to the second timing is input to the first input node, and a clock signal with a different phase is input to the second input node.

8. The time to digital converter according to any one of Claims 1 to 7, wherein
the third circuit (23) includes a selection circuit (234) configured to receive, as inputs, a plurality of signals output from the plurality of flip-flop circuits, the plurality of latch circuits, or the flip-flop circuit and the latch circuit and a selection signal, select one signal from among the plurality of signals by using the selection signal, and output the one signal.

9. The time to digital converter according to any one of Claims 1 to 8, wherein
the third circuit (23) includes a generation circuit (235) configured to generate the selection signal.

10. The time to digital converter according to Claim 9, wherein
the generation circuit (235) includes an output node and a plurality of input nodes, the plurality of input nodes are connected to the first circuit (21), and the output node is connected to the selection circuit (234).

11. The time to digital converter according to any one of Claims 1 to 10, wherein
the first circuit (21) includes a differentiation circuit (212) configured to generate the first signal by performing differentiation processing on a signal output from each of the plurality of flip-flop circuits, each of the plurality of latch circuits, or each of the flip-flop circuit and the latch circuit which are included in the first circuit (21), and the plurality of output nodes included in the differentiation circuit (212) are connected to the plurality of input nodes included in the generation circuit (235).

12. The time to digital converter according to any one of Claims 1 to 11, wherein
the third circuit (23) includes a timing adjustment circuit (236) configured to compensate for a delay of signal processing which has occurred in at least one of the first circuit (21) and the third circuit (23).

13. A distance measuring apparatus comprising:
light receiving means (10) for receiving pulsed light which has been emitted towards a target object and reflected in the target object; and
the time to digital converter (80) according to any one of Claims 1 to 12, wherein
in a case where a timing at which the pulsed light has been emitted is set as the first timing and a timing at which the pulsed light has been received is set as the second timing, the time to digital converter (80) acquires distance information of a distance to the target object based on the time interval digital data corresponding to the time interval from the first timing to the second timing.

14. The distance measuring apparatus according to Claim 13, further comprising light emitting means (110) for emitting the pulsed light.

15. The distance measuring apparatus according to Claim 14, wherein
the light receiving means (10) includes a plurality of light receiving means, the plurality of light receiving means being arranged across a plurality of rows and a plurality of columns, and
the first circuit (21), the second circuit (22), and the third circuit (23) are provided for each row among the plurality of rows.

16. The distance measuring apparatus according to Claim 14, wherein
the light receiving means (10) includes a plurality of light receiving means, the plurality of light receiving means being arranged across a plurality of rows and a plurality of columns, and
the first circuit (21), the second circuit (22), and the third circuit (23) are provided for each of the light receiving means (10).

17. The distance measuring apparatus according to Claim 14, wherein
the light receiving means (10) includes a plurality of light receiving means, the plurality of light receiving means being arranged across a plurality of rows and a plurality of columns, and
the first circuit (21), the second circuit (22), and the third circuit (23) are provided for each subarray including the plurality of light receiving means (10).

18. A moving object comprising:
the distance measuring apparatus (802, 803) according to Claim 14; and
control means (820) for controlling the moving object based on the distance information acquired by the distance measuring apparatus (802, 302).

19. An equipment comprising the time to digital converter (930) according to any one of Claims 1 to 12, wherein
the equipment (9191) further comprises at least any of
an optical apparatus (940) configured to guide light to the time to digital converter (930),
a control apparatus (950) configured to control the time to digital converter (930),
a processing apparatus (960) configured to process a signal output from the time to digital converter (930),
a display apparatus (970) configured to display information acquired in the time to digital converter (930),
a storage device (980) configured to store information acquired in the time to digital converter (930), and
a mechanical apparatus (990) arranged to operate based on information acquired in the time to digital converter (930).
